(19) Europäisches Patentamt / European Patent Office / Office européen des brevets

(11) **EP 2 700 967 B1**

## (12) EUROPÄISCHE PATENTSCHRIFT

(45) Veröffentlichungstag und Bekanntmachung des Hinweises auf die Patenterteilung:
**10.08.2016 Patentblatt 2016/32**

(51) Int Cl.:
***G01R 33/04*** *(2006.01)*

(21) Anmeldenummer: **13181195.2**

(22) Anmeldetag: **21.08.2013**

(54) **Magnetfeldsensor**

Magnetic field sensor

Capteur de champ magnétique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.08.2012 DE 102012214892**

(43) Veröffentlichungstag der Anmeldung:
**26.02.2014 Patentblatt 2014/09**

(73) Patentinhaber:
• **Fraunhofer-Gesellschaft zur Förderung der angewandten Forschung e.V.
80686 München (DE)**
• **Technische Universität Ilmenau
98693 Ilmenau (DE)**

(72) Erfinder:
• **Rybalko, Ruslan
90480 Nürnberg (DE)**
• **Hofmann, Christian
90425 Nürnberg (DE)**
• **Haueisen, Jens
07751 Jena (DE)**

(74) Vertreter: **Schenk, Markus et al
Schoppe, Zimmermann, Stöckeler
Zinkler, Schenk & Partner mbB
Patentanwälte
Radlkoferstrasse 2
81373 München (DE)**

(56) Entgegenhaltungen:
**EP-A1- 0 360 574          US-A- 3 218 547
US-A1- 2007 151 943**

**Beschreibung**

Ausführungsbeispiele der vorliegenden Erfindung beziehen sich auf einen Magnetfeldsensor. Weitere Ausführungsbeispiele der vorliegenden Erfindung beziehen sich auf ein Verfahren zum Detektieren eines externen Magnetfelds. Einige Ausführungsbeispiele beziehen sich auf eine Vorrichtung und ein Verfahren zur hochauflösenden Messung von Magnetfeldern für schwache Feldstärken und kleinste Amplituden. Einige Ausführungsbeispiele beziehen sich auf einen neuen Aufbau bzw. ein neues Modell des Fluxgate-Sensors zur Erfassung von sehr schwachen Magnetfeldern.

Ein Fluxgate-Magnetometer ist ein Sensorelement bzw. Messgerät zur vektoriellen Bestimmung des Magnetfeldes. Fluxgate-Magnetometer werden auch als Saturationskern-Magnetometer oder im deutschen Sprachraum nach dem Erfinder (1937) Friedrich Förster als "Förster-Sonde" bezeichnet. Die englische Bezeichnung und die im wissenschaftlichen Bereich am häufigsten genutzte Bezeichnung lautet Fluxgate-Sensor.

Die jährlich veröffentlichten Beiträge und Patente belegen das breite Anwendungsspektrum von Fluxgate-Sensoren. Heute lassen sich Fluxgate-Sensoren in vielfältigen Anwendungsszenarien einsetzen. Sie sind unverzichtbar bei der präzisen Messung magnetischer Felder wie zum Beispiel an Bord von Satelliten und in Flugzeugen sowie zur Kartierung der Feinstruktur des Erdmagnetfelds, z.B. in der Erkundung von Ölvorkommen. In Flughäfen werden sie zum Aufspüren von Feuerwaffen benutzt, Bibliotheken und Kaufhäuser schützen ihre Waren vor Diebstahl mit magnetischen Etiketten, welche von Fluxgate-Sensoren erfasst werden. Die Marine benutzt Magnetometer, um U-Boote unter Wasser aufzuspüren und Geographen lokalisieren bei Vermessungsarbeiten mit Hilfe von Fluxgate-Sensoren im Boden vergrabene oder durch Vegetation verdeckte Grenzzeichen.

Ein Fluxgate-Sensor ist eine Vorrichtung, die für externe magnetische Felder empfindlich ist. Mit heutigen Technologien können sowohl statische Magnetfelder mit konstanter Feldstärke bzw. quasistatische Magnetfelder mit geringer Amplitudenänderung als auch dynamische Wechselfelder mit variabler Amplitude und einer Frequenz bis zu einigen kHz gemessen werden.

Mit Fluxgate-Sensoren lassen sich Magnetfelder mit einer Feldstärke von 1 mT bis hin zu kleinsten Feldstärken von ca. 10 pT messen, wobei mit Sensoren nach dem aktuellen Stand der Technik, Messung mit einer Auflösung von 10 pT allerdings nur mit Einschränkungen möglich ist (z.B. bei niedrigen Frequenzen und mit nachgeschaltetem Mittelungsverfahren). Das Erdmagnetfeld liegt beispielsweise im Bereich von ca. 30 $\mu$T...40 $\mu$T, geomagnetische Signale wie das Magnetkardiogramm (MKG) weisen Werte um 50 pT auf.

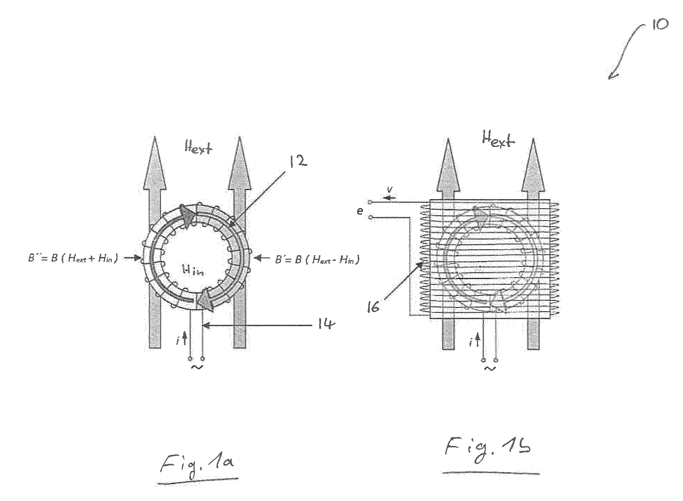

Ein klassischer Fluxgate-Sensor 10 besteht aus einem ferromagnetischen, hochpermeablen Kern 12, über den zwei Spulenwicklungen 14 und 16 aufgebracht sind (Primärspule 14 und Sekundärspule 16). In klassischer Bauform ist die Sekundärspule 16 so angeordnet, dass sie die Primärspule umfasst (siehe Fig. 1a und 1b).

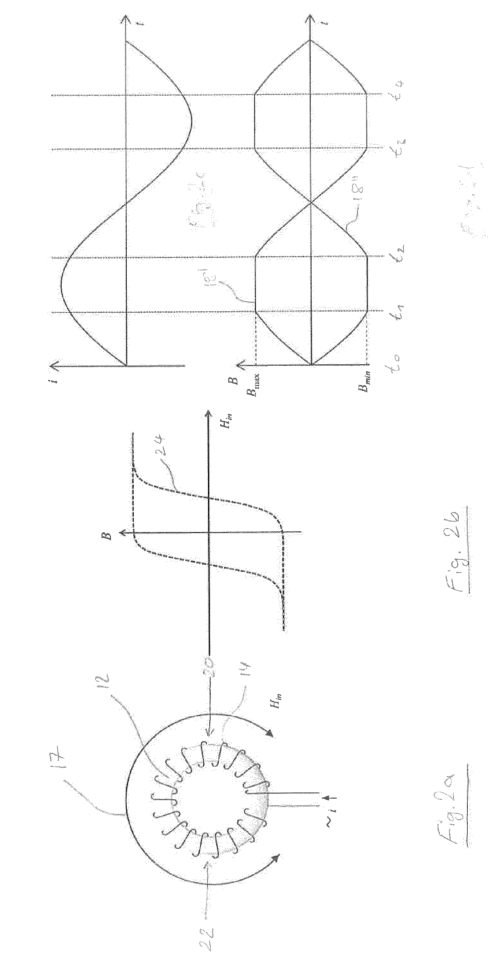

Fig. 1a zeigt dabei den Fluxgate-Sensor 10 ohne Sekundärspule 16, um eine aussagekräftigere Darstellung des ferromagnetischen Ringkerns 12 und der Primärspule 14 mit den Wicklungen um den ferromagnetischen Ringkern 12 zu ermöglichen, während Fig. 1b den Fluxgate-Sensor 10 mit Sekundärspule 16 zeigt.
Im Folgenden wird die genaue Funktionsweise des in Fig. 1b gezeigten Fluxgate-Sensors 10 anhand der Fig. 2a bis 4e genauer erläutert.

Fig. 2a zeigt eine schematische Ansicht des ferromagnetischen Ringkerns 12 und der Primärspule 14 mit den Wicklungen um den ferromagnetischen Ringkern 12. Durch Einprägen eines Stroms i (Magnetisierungsstrom) in die Primärspule 14 wird im Inneren der Primärspule ein Magnetfeld 17 mit der Feldstärke $H_{in}$ erzeugt, wodurch sich der ferromagnetische Ringkern 12 magnetisiert und die magnetische Flussdichte B im Inneren des ferromagnetischen Ringkerns 12 erhöht. Die magnetische Feldstärke $H_{in}$ und die magnetische Flussdichte B weisen dabei an zwei gegenüberliegenden Punkten 20 und 22 des ferromagnetischen Ringkerns 12 unterschiedliche Vorzeichen auf. Im Falle der magnetischen Flussdichte wird dies im Folgenden mit B' und B" gekennzeichnet.

Fig. 2b zeigt in einem Diagramm die Hystereskurve 24 des in Fig. 2a gezeigten ferromagnetischen Ringkerns 12. Wie in Fig. 2b zu erkennen ist, wird die magnetische Flussdichte B in dem ferromagnetischen Ringkern 12 von der magnetischen Feldstärke $H_{in}$ bestimmt. Ferner ist zu erkennen, dass wenn die magnetische Feldstärke $H_{in}$ genügend erhöht wird, die magnetische Flussdichte B wegen der Sättigung des ferromagnetischen Ringkerns 12 ab der magnetischen Sättigungsfeldstärke nur noch sehr geringfügig ansteigt. Fig. 2c zeigt in einem Diagramm den Verlauf der Stromstärke des in die Primärspule 14 eingeprägten Stroms i. Dabei beschreibt die Ordinate die Stromstärke, während die Abszisse die Zeit t beschreibt.

Fig. 2d zeigt in einem Diagramm Verläufe der magnetischen Flussdichte an zwei gegenüberliegenden Punkten 20 und 22 des ferromagnetischen Ringkerns 12 in Abhängigkeit von dem Strom i, der in die Primärspule 14 eingeprägt wird. Dabei beschreibt die Ordinate die magnetische Flussdichte B, während die Abszisse die Zeit t beschreibt. Wie in Fig. 2d zu erkennen ist, beschreibt eine erste Kurve 18' den Verlauf der magnetischen Flussdichte B' an einem ersten Punkt 20 der zwei gegenüberliegenden Punkten 20 und 22, während eine zweite Kurve 18" den Verlauf der magnetischen Flussdichte B" an einem zweiten Punkt 22 der zwei gegenüberliegenden Punkte 20 und 22 beschreibt.

Zum Zeitpunkt $t_0$ ist die Stromstärke des Stroms i Null, so dass auch die magnetische Flussdichte B an dem ersten und zweiten Punkt 20 und 22 Null ist. Zwischen den Zeitpunkten $t_0$ und $t_1$ steigt die Stromstärke des Stroms i, so dass die magnetische Flussdichte B' an dem ersten Punkt 20 steigt, während die magnetische Flussdichte B" an dem zweiten Punkt 22 fällt, so dass die magnetischen Flussdichten B' und B" an den Punkten 20 und 22 entgegengesetzte Vektoren bilden. Ab dem Zeitpunkt $t_1$ ist die Stromstärke des Stroms i so weit gestiegen, dass der ferromagnetische Kern 12 in Sättigung ist und die magnetische Flussdichte B' an dem ersten Punkt 20 ihr Maximum $B_{max}$ erreicht, während die magnetische Flussdichte B" an dem zweiten Punkt 22 ihr Minimum $B_{min}$ erreicht. Zwischen den Zeitpunkten $t_1$ und $t_2$ weist die Stromstärke ihr Maximum auf, die magnetische Flussdichte B' an dem ersten Punkt 20 und die magnetische Flussdichte B" an dem zweiten Punkt 22 bleiben jedoch (nahezu) konstant. Zum Zeitpunkt $t_2$ ist die Stromstärke des Stroms i wieder so weit gefallen, dass der ferromagnetische Ringkern 12 aus der Sättigung gelangt. Zwischen den Zeitpunkten $t_2$ und $t_3$ fällt die Stromstärke des Stroms i zunächst bis auf null ab und kehrt sich dann um, so dass die magnetische Flussdichte B' an dem ersten Punkt 20 fällt, während die magnetische Flussdichte B" an dem zweiten Punkt 22 steigt. Ab dem Zeitpunkt $t_3$ ist die Stromstärke des Stroms i so weit gefallen, dass der ferromagnetische Kern 12 in Sättigung ist und die magnetische Flussdichte B' an dem ersten Punkt 20 ihr Minimum $B_{min}$ erreicht, während die magnetische Flussdichte B" an dem zweiten Punkt 22 ihr Maximum $B_{max}$ erreicht. Zwischen den Zeitpunkten $t_3$ und $t_4$ weist die Stromstärke ihr Minimum auf, der Betrag der magnetischen Flussdichte B' an dem ersten Punkt 20 und der Betrag der magnetischen Flussdichte B" an dem zweiten Punkt 22 bleiben jedoch (nahezu) konstant. Zum Zeitpunkt $t_4$ ist die Stromstärke des Stroms i wieder so weit gestiegen, dass der ferromagnetische Ringkern 12 aus der Sättigung gelangt. Ab dem Zeitpunkten $t_4$ steigt die Stromstärke des Stroms i weiter an, so dass die magnetische Flussdichte B' an dem ersten Punkt 20 steigt, während die magnetische Flussdichte B" an dem zweiten Punkt 22 fällt.

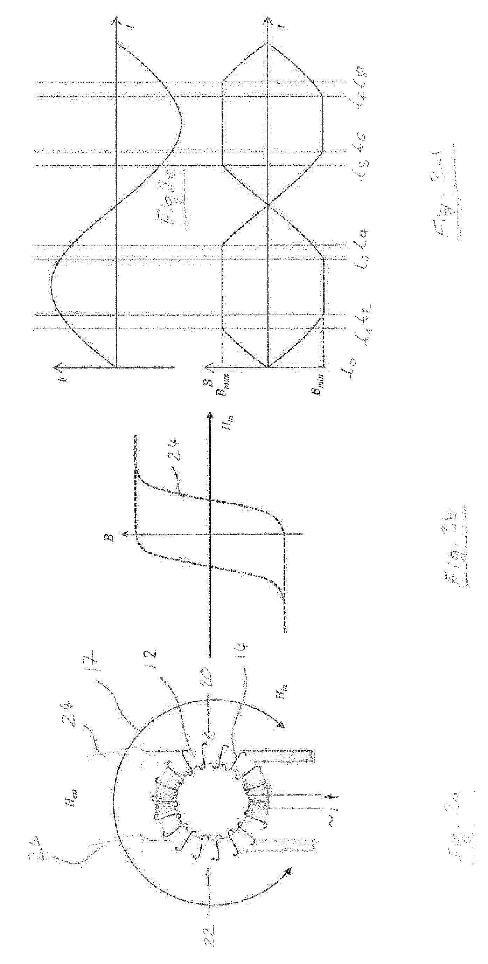

Fig. 3a zeigt eine schematische Ansicht des ferromagnetischen Ringkerns 12 und der Primärspule 14 mit den Wicklungen um den ferromagnetischen Ringkern 12 in Anwesenheit eines externen Magnetfelds 24. Das externe Magnetfeld 24 und das Magnetfeld 17 im Inneren der Primärspule 14 überlagern sich, so dass sich die magnetische Feldstärke $H_{in}$ des inneren Magnetfelds 17 und die magnetische Feldstärke $H_{ext}$ des externen Magnetfelds 24 in Abhängigkeit des Stroms i, der in die Primärspule 14 eingeprägt wird, konstruktiv oder destruktiv überlagern.

Fig. 3b zeigt in einem Diagramm die Hystereskurve 24 des in Fig. 2a gezeigten ferromagnetischen Ringkerns 12.

Fig. 3c zeigt in einem Diagramm den Verlauf des Stroms i, der in die Primärspule 14 eingeprägt wird. Da die Fig. 3b und 3c den Fig. 2b und 2c entsprechen, wird auf die Beschreibung der Fig. 2b und 2c verwiesen.

Fig. 3d zeigt in einem Diagramm Verläufe der magnetischen Flussdichte an zwei gegenüberliegenden Punkten 20 und 22 des ferromagnetischen Ringkerns 12 in Abhängigkeit des externen Magnetfelds und des in die Primärspule 14 eingeprägten Stroms i. Dabei beschreibt die Ordinate die magnetische Flussdichte B, während die Abszisse die Zeit t beschreibt. Wie in Fig. 2d zu erkennen ist, beschreibt eine erste Kurve 18' den Verlauf der magnetischen Flussdichte B' an einem ersten Punkt 20 der zwei gegenüberliegenden Punkten 20 und 22, während eine zweite Kurve 18" den Verlauf der magnetischen Flussdichte B" an einem zweiten Punkt 22 der zwei gegenüberliegenden Punkten 20 und 22 beschreibt. Im Gegensatz zu Fig. 2d ist in Fig. 3d zu erkennen, dass bei einem positiven Strom i der erste Punkt 20 des ferromagnetischen Kerns 12 durch die konstruktive Überlagerung der magnetischen Feldstärke $H_{in}$ des inneren Magnetfelds 17 und der magnetische Feldstärke $H_{ext}$ des externen Magnetfelds 24 bereits zum Zeitpunkt $t_1$ in Sättigung gelangt, während der zweite Punkt 22 des ferromagnetischen Kerns 12 durch die destruktive Überlagerung der magnetischen Feldstärke $H_{in}$ des inneren Magnetfelds 17 und der magnetische Feldstärke $H_{ext}$ des externen Magnetfelds 24 erst ab dem Zeitpunkt t2 in Sättigung gelangt. Dementsprechend gelangt der zweite Punkt 22 des ferromagnetischen Kerns 12 bereits zum Zeitpunkt $t_3$ aus der Sättigung, während der erste Punkt 20 des ferromagnetischen Kerns 12 erst ab dem Zeitpunkt $t_4$ aus der Sättigung gelangt.

Analog zu dem vorherigen, gelangt bei einem negativen Strom i der zweite Punkt 22 des ferromagnetischen Kerns 12 durch die konstruktive Überlagerung der magnetischen Feldstärke $H_{in}$ des inneren Magnetfelds 17 und der magnetische Feldstärke $H_{ext}$ des externen Magnetfelds 24 bereits zum Zeitpunkt $t_5$ in Sättigung, während der erste Punkt 20 des ferromagnetischen Kerns 12 durch die destruktive Überlagerung der magnetischen Feldstärke $H_{in}$ des inneren Magnetfelds 17 und der magnetische Feldstärke $H_{ext}$ des externen Magnetfelds 24 erst ab dem Zeit-

punkt $t_6$ in Sättigung gelangt. Dementsprechend gelangt der erste Punkt 20 des ferromagnetischen Kerns 12 bereits zum Zeitpunkt $t_7$ aus der Sättigung, während der zweite Punkt 20 des ferromagnetischen Kerns 12 erst ab dem Zeitpunkt $t_8$ aus der Sättigung gelangt.

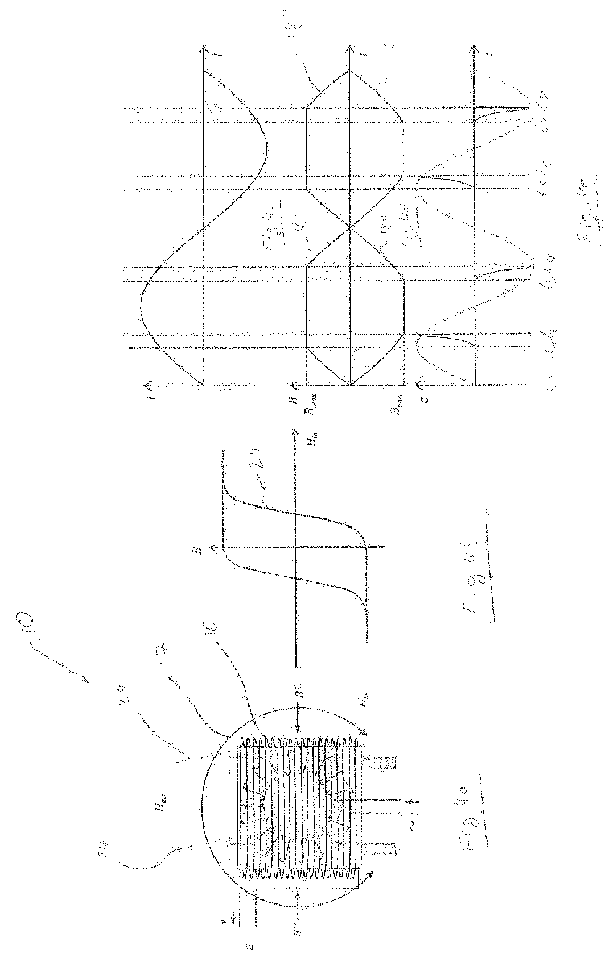

Fig. 4a zeigt eine schematische Ansicht eines Fluxgate-Sensors 10. Wie bereits erwähnt, weist der Fluxgate-Sensor 10 einen ferromagnetischen Ringkern 12, eine Primärspule 14 mit Wicklungen um den ferromagnetischen Ringkern 12, und eine Sekundärspule, die den ferromagnetischen Ringkern 12 und die Primärspule 14 einhüllt, auf.

Fig. 4b zeigt in einem Diagramm die Hystereskurve 24 des in Fig. 4a gezeigten ferromagnetischen Ringkerns 12.

Fig. 4c zeigt in einem Diagramm den Verlauf des Stroms i, der in die Primärspule 14 eingeprägt wird.

Fig. 4d zeigt in einem Diagramm Verläufe der magnetischen Flussdichte an zwei gegenüberliegenden Punkten 20 und 22 des ferromagnetischen Ringkerns 12 in Abhängigkeit von dem Strom i, der in die Primärspule 14 eingeprägt wird.

Da die Fig. 4b bis 4d den Fig. 3b bis 3d entsprechen, wird auf die Beschreibung der Fig. 3b bis 3d verwiesen.

Fig. 4e zeigt in einem Diagramm einen Verlauf der in die Sekundärspule 16 induzierten Spannung e. Wie in Fig. 4e zu erkennen ist, wird in die Sekundärspule 16 eine Spannung zwischen den Zeitpunkten $t_1$ und $t_2$, $t_3$ und $t_4$, $t_5$ und $t_6$, und $t_7$ und $t_8$ induziert. Die in die Sekundärspule 16 induziere Spannung e steigt (oder fällt) dabei an, wenn ein erster der zwei gegenüberliegenden Punkte 20 und 22 (z.B. der erste Punkt 20 zum Zeitpunkt $t_1$) in Sättigung gelangt und erreicht ihr Maximum (oder Minium) kurz bevor ein zweiter der zwei gegenüberliegenden Punkte 20 und 22 (z.B. der zweite Punkt 22 zum Zeitpunkt $t_2$) in Sättigung gelangt. Anschließend fällt (oder steigt) die in die Sekundärspule 16 induziere Spannung wieder rapide ab (oder an). Die in die Sekundärspule 16 induziere Spannung e lässt sich wie folgt berechnen:

$$e = -s\omega_2 \frac{d}{dt}(B' + B'')$$

Dabei ist s die Windungszahl der Sekundärspule 16 und $\omega_2$ die Kreisfrequenz mit der die Sekundärspule 16 betrieben wird.

Zusammenfassend, über die Primärspule (Magnetisierungsspule) 14 wird mittels eines Wechselstroms i bei einer bestimmten Frequenz der Ringkern 12 periodisch bis in die Sättigung magnetisiert. In der Sekundärspule (Detektionsspule) 16, welche die Primärspule 14 räumlich umfasst bzw. umschließt, überlagern sich das externe Magnetfeld $H_{ext}$ und das durch die Primärspule 14 induzierte Magnetfeld $H_{in}$. Aufgrund der geometrischen Anordnung kommt es zu einer destruktiven (oder konstruktiven) Überlagerung des induzierten Magnetfelds.

Für zwei gegenüberliegende Punkte 20 und 22 im Ferritkern 12 gilt:

$$B' = B(H_{ext} - H_{in})$$

$$B'' = B(H_{ext} + H_{in})$$

Dieser Unterschied in den lokalen Magnetfeldstärken innerhalb des Ringkerns 12 induziert in der Sekundärspule (Detektionsspule) 16 eine Spannung. Die in der Sekundärspule 16 induzierte Spannung ist somit ein Maß für das externe Magnetfeld 24.

In vielen Fällen ist eine wesentliche Grundlage zur Messung von Magnetfeldern mit Fluxgate-Sensoren 10 die entsprechende Auslegung von Primärspule 14 und Sekundärspule 16: die Sekundärspule 16 wird in den meisten Fällen mit der doppelten Frequenz des Anregungsstroms in der Primärspule 14 betrieben (zweite Harmonische, vgl. mit der Veröffentlichung "Review of fluxgate sensors" von Pavel Ripka). Nur in wenigen Fällen wird die Sekundärspule 16 mit der gleichen Frequenz betrieben, mit der auch der Ringkern 12 durch den Wechselstrom i der Primärspule 14 magnetisiert wird. Die Abstimmung der Sekundärspule 16 auf die erste oder zweite Harmonische erfordert eine entsprechende Kalibrierung des Gesamtsystems (des Fluxgate-Sensors 10). Eine ungenaue Kalibrierung verfälscht die Messwerte und senkt die Empfindlichkeit des Fluxgate-Sensors 10. Zudem wird durch die Spezifikation klassischer Fluxgate-Sensoren (Anzahl Spulenwicklungen) 10 die Betriebsfrequenz der Schwingkreise festgelegt.

In der Veröffentlichung "Review of Fluxgate Sensors" von Pavel Ripka werden einige verbreitete Typen von Fluxgate-Magnetometern beschrieben, die Funktionsweise der Sensoren erörtert und verschiedene Abnehm-Methoden der Signale betrachtet.

In der Veröffentlichung "A New Type of Fluxgate Magnetometer for Low Magnetic Fields" von Derac Son wird eine neue Methode beschrieben, um magnetische Signale zu erfassen. Diese Methode ermöglicht es, schwache magnetische Felder zu messen.

Das bestehende Grundprinzip von Fluxgate-Sensoren 10 setzt für die Messung der induzierten Spannung eine Sekundärwicklung 16 voraus. Für sehr empfindliche Fluxgate-Sensoren 10 sind Sekundärspulen 16 mit einer großen Anzahl von Windungen nötig (Empfindlichkeit). Dies führt aber zu den im Folgenden genannten Nachteilen. Erstens, zu großen mechanischen Abmessungen, womit keine weitere Miniaturisierung des Fluxgate-Sensors 10 möglich ist. Zweitens, zu hohen parasitären Kapazitäten zwischen den einzelnen Spulenwicklungen, die zu einem Schwingkreisverhalten führen. Drittens, zu einem erhöhten parasitären Widerstand durch die vielen Spulenwicklungen, womit mehr Verluste erzeugt werden.

Zudem ist für die oben beschriebene Betriebsart (Messung der induzierten Spannung in der Sekundärspule 16 als zweite Harmonische des Anregungsstromes in der Primärspule) eine entsprechende Abstimmung und Kalibrierung des Schwingkreises notwendig.

Zusammenfassend lassen sich als Nachteile aktueller Fluxgate-Sensoren 10 die im Folgenden genannten Eigenschaften aufführen. Erstens, es sind zwei Spulenwicklungen notwendig (Primär- und Sekundärspule 14 und 16). Zweitens, es ist eine Abstimmung des Sekundär-Schwingkreises 16 erforderlich (Abstimmung auf die erste oder zweite Harmonische des Primärschwingkreises 14). Drittens, durch Festlegung der Wicklungsanzahl in Primär- und Sekundärspule 14 und 16 weist der klassische Fluxgate-Sensor 10 eine feste Betriebsfrequenz auf. Viertens, Messungen in der Sekundärspule 16 müssen mit einer festen Frequenz erfolgen und limitieren daher die maximal messbare Frequenz des externen Magnetfeldes (Abtasttheorem). Fünftens, mit einer niedrigen Sekundärwicklungszahl kann nur eine geringe Empfindlichkeit erreicht werden (nur große Unterschiede des externen Magnetfelds). Sechstens, bei empfindlichen Fluxgate-Sensoren 10 mit hoher Sekundärwicklungszahl ist aufgrund der mechanischen Voraussetzungen eine weitere Miniaturisierung nur sehr schwer möglich.

Die WO 2010/020648 A1 zeigt einen Fluxgate-Sensor mit einem ferromagnetischen Kern, einer Anregungsspule und einer Abnehmerspule. Anstatt separate Spulen für die Anregungsspule und die Abnehmerspule zu verwenden, werden die Anregungsspule und die Abnehmerspule mittels einer herkömmlichen Spule implementiert. Die Spule ist dabei in zwei Hälften unterteilt, die seriell verschaltet sind und einen gemeinsamen Mittelanschluss aufweisen. Der Fluxgate-Sensor nutzt eine Stromquelle, die einen Wechselstrom in die Spule mit den zwei seriell verschalteten Hälften einprägt. Im Gebrauch werden die Spannungen, die in die beiden Hälften der Spule induziert werden, summiert und ausgewertet. Die US 3 218 547 A zeigt einen Fluxgate-Sensor mit einem zylinderförmigen Kern, einer toroidalen Anregungsspule und einer solenoidalen Ausgangsspule, die darum gewickelt ist.

Die US 2007/151943 A1 zeigt einen Fluxgate-Sensor, der in einer Leiterplatte integriert ist.

Die EP 0 360 574 A1 zeigt einen Stromsensor mit einem amorphen magnetischem Material.

Der vorliegenden Erfindung liegt somit die Aufgabe zugrunde, ein Konzept zum Detektieren eines externen Magnetfelds zu schaffen, das die oben genannten Nachteile vermeidet. Diese Aufgabe wird durch einen Magnetfeldsensor gemäß Anspruch 1, ein Verfahren gemäß Anspruch 12 und einem Computerprogramm gemäß Anspruch 13 gelöst. Ausführungsbeispiele der vorliegenden Erfindung schaffen einen Magnetfeldsensor mit einem ersten Strompfad, einem zweiten Strompfad, einem Signalgenerator und eine Auswerteeinrichtung. Der erste Strompfad weist einen ersten Spulenbereich und der zweite Strompfad einen zweiten Spulenbereich auf, wobei der erste Spulenbereich Wicklungen in einer ersten Wickelrichtung um einen ersten magnetischen Kernbereich aufweist, und wobei der zweite Spulenbereich Wicklungen in einer zweiten Wickelrichtung um einen zweiten magnetischen Kernbereich aufweist. Der Signalgenerator ist ausgebildet, um einen Anregungsstrom bereitzustellen, der sich auf den ersten und zweiten Strompfad aufteilt. Die Auswerteeinrichtung ist ausgebildet, um eine Spannung zwischen dem ersten und zweiten Spulenbereich und abzugreifen, und um basierend auf der Spannung ein externes Magnetfeld zu detektieren.

Weitere Ausführungsbeispiele der vorliegenden Erfindung schaffen einen Magnetfeldsensor mit einem ersten und zweiten Spulenbereich, einem Signalgenerator und einer Auswerteeinrichtung. Der erste Spulenbereich weist Wicklungen in einer ersten Wickelrichtung um einen ersten magnetischen Kernbereich auf, wobei der zweite Spulenbereich Wicklungen in einer zweiten Wickelrichtung um einen zweiten magnetischen Kernbereich aufweist. Der Signalgenerator ist ausgebildet, um einen ersten Strom in den ersten Spulenbereich und einen zweiten Strom in den zweiten Spulenbereich einzuprägen. Die Auswerteeinrichtung ist ausgebildet, um eine Spannung zwischen dem ersten und zweiten Spulenbereich abzugreifen, und um basierend auf der Spannung ein externes Magnetfeld zu detektieren.

Bei Ausführungsbeispielen weist der erste Spulenbereich Wicklungen in einer ersten Wickelrichtung um einen ersten magnetischen Kernbereich auf, wobei der zweite Spulenbereich Wicklungen in einer zweiten Wickelrichtung um einen zweiten magnetischen Kernbereich aufweist. Durch Bereitstellen eines Anregungsstroms, der sich auf den ersten und zweiten Strompfad aufteilt, entsteht in dem ersten Spulenbereich ein erstes Magnetfeld $H_1$, dass den ersten magnetische Kernbereich magnetisiert und eine erste magnetische Flussdichte B' hervorruft, die in eine erste Richtung gerichtet ist, während in dem zweiten Spulenbereich ein zweites Magnetfeld $H_2$ entsteht, dass den zweiten magnetischen Kernbereich magnetisiert und eine zweite magnetische Flussdichte B" hervorruft, die in eine zweite Richtung gerichtet ist. Durch ein in die erste Richtung gerichtetes externes Magnetfeld wird die erste magnetische Flussdichte B' in dem ersten Kernbereich erhöht, während die zweite magnetische Flussdichte B" in dem zweiten Kernbereich reduziert wird. Dies führt dazu, dass bei gleichzeitiger Erhöhung des Anregungsstroms der erste magnetische Kernbereich zu einem ersten Zeitpunkt in Sättigung gelangt, während der zweite magnetische Kernbereich zu einem zweiten Zeitpunkt in Sättigung gelangt. Zwischen dem ersten Zeitpunkt und dem zweiten Zeitpunkt weisen der erste und zweite Spulenbereich unterschiedliche elektrische Eigenschaften auf, so dass die Auswerteeinrichtung basierend auf der Spannung zwischen dem ersten Spulenbereich und dem zweiten Spulenbereich das externe Magnetfeld des detektieren kann.

Weitere Ausführungsbeispiele schaffen ein Verfahren zum Detektieren eines externen Magnetfelds. In einem ersten Schritt wird ein Anregungsstroms bereitgestellt, der sich auf einen ersten Strompfad mit einem ersten Spulenbereich und einen zweiten Strompfad mit einem zweiten Spulenbereich aufteilt, wobei der erste Spulenbereich Wicklungen in einer ersten Wickelrichtung um einen ersten magnetischen Kernbereich aufweist, wobei der zweite Spulenbereich Wicklungen in einer zweiten Wickelrichtung um einen zweiten magnetischen Kernbereich aufweist, und wobei der erste Spulenbereich und der zweite Spulenbereich parallel zueinander verlaufen. In einem zweiten Schritt wird eine Spannung zwischen dem ersten und zweiten Spulenbereich abgegriffen. In einem dritten Schritt wird das externe Magnetfeld basierend auf der Spannungsdifferenz zwischen dem ersten und zweiten Spulenbereich detektiert.

Weitere Ausführungsbeispiele schaffen ein Verfahren zum Detektieren eines externen Magnetfelds. In einem ersten Schritt wird ein erster Strom in einen ersten Spulenbereich und ein zweiter Strom in einen zweiten Spulenbereich eingeprägt, wobei der erste Spulenbereich Wicklungen in einer ersten Wickelrichtung um einen ersten magnetischen Kembereich aufweist, und wobei der zweite Spulenbereich Wicklungen in einer zweiten Wickelrichtung um einen zweiten magnetischen Kernbereich aufweist. In einem zweiten Schritt wird eine Spannung zwischen dem ersten und zweiten Spulenbereich abgegriffen. In einem dritten Schritt wird das externe Magnetfeld basierend auf der Spannungsdifferenz zwischen dem ersten und zweiten Spulenbereich detektiert.

Ausführungsbeispiele der vorliegenden Erfindung werden Bezug nehmend auf die beiliegenden Zeichnungen näher erläutert. Es zeigen:

Fig. 1a     eine schematische Ansicht eines Fluxgate-Sensors ohne Sekundärspule;

Fig. 1b     eine schematische Ansicht des Fluxgate-Sensors mit Sekundärspule;

Fig. 2a     eine schematische Ansicht des ferromagnetischen Ringkerns und der Primärspule mit den Wicklungen um den ferromagnetischen Ringkern;

Fig. 2b     in einem Diagramm die Hystereskurve des in Fig. 2a gezeigten fenomagnetischen Ringkerns;

Fig. 2c     in einem Diagramm den Verlauf der Stromstärke des in die Primärspule eingeprägten Stroms;

Fig. 2d     in einem Diagramm Verläufe der magnetischen Flussdichte an zwei gegenüberliegenden Punkten des ferromagnetischen Ringkerns in Abhängigkeit des in die Primärspule eingeprägten Stroms;

Fig. 3a     eine schematische Ansicht des ferromagnetischen Ringkerns und der Primärspule mit den Wicklungen um den ferromagnetischen Ringkern in Anwesenheit eines externen Magnetfelds;

Fig. 3b     in einem Diagramm die Hystereskurve des in Fig. 3a gezeigten ferromagnetischen Ringkerns;

Fig. 3c     in einem Diagramm den Verlauf der Stromstärke des in die Primärspule eingeprägten Stroms;

Fig. 3d     in einem Diagramm Verläufe der magnetischen Flussdichte an zwei gegenüberliegenden Punkten des ferromagnetischen Ringkerns in Abhängigkeit des externen Magnetfelds und des in die Primärspule eingeprägten Stroms;

Fig. 4a     eine schematische Ansicht eines Fluxgate-Sensors;

Fig. 4b     in einem Diagramm die Hystereskurve des in Fig. 4a gezeigten ferromagnetischen Ringkerns;

Fig. 4c     in einem Diagramm den Verlauf der Stromstärke des in die Primärspule eingeprägten Stroms;

Fig. 4d     in einem Diagramm Verläufe der magnetischen Flussdichte an zwei gegenüberliegenden Punkten des ferromagnetischen Ringkerns in Abhängigkeit des externen Magnetfelds und des in die Primärspule eingeprägten Stroms;

Fig. 4e     in einem Diagramm einen Verlauf der in die Sekundärspule induzierten Spannung;

Fig. 5     ein Blockschaltbild eines Magnetfeldsensors gemäß einem Ausführungsbeispiel der vorliegenden Erfindung;

Fig. 6a     ein Blockschaltbild eines Magnetfeldsensors gemäß einem weiteren Ausführungsbeispiel der vorliegenden Erfindung;

Fig. 6b     in einem Diagramm den Verlauf der Stromstärke des ersten Stroms, der in die erste Spule eingeprägt wird, und des zweiten Stroms, der in die zweite Spule eingeprägt wird;

Fig. 6c     in einem Diagramm den Verlauf der ersten magnetischen Flussdichte im ersten Kernbereich und den Verlauf der zweiten magnetischen Flussdichte im zweiten Kernbereich;

Fig. 6d     in einem Diagramm den Verlauf der Ausgangsspannung des Differenzverstärkers;

Fig. 7     ein Blockschaltbild eines Magnetfeldsensors gemäß einem Ausführungsbeispiel der vorliegenden Erfindung;

Fig. 8a     in einem Diagramm die Hysteresekurve des in Fig. 7 gezeigten ferromagnetischen Ringkerns, wobei ein erster Punkt die erste magnetische Flussdichte und ein zweiter Punkt die zweite magnetische Flussdichte kennzeichnet;

Fig. 8b     in einem Diagramm die Hysteresekurve des in Fig. 7 gezeigten ferromagnetischen Ringkerns, wobei ein erster Punkt die erste magnetische Flussdichte und ein zweiter Punkt die zweite magnetische Flussdichte kennzeichnet;

Fig. 8c     in einem Diagramm die Hysteresekurve des in Fig. 7 gezeigten ferromagnetischen Ringkerns, wobei ein erster Punkt die erste magnetische Flussdichte und ein zweiter Punkt die zweite magnetische Flussdichte kennzeichnet; und

Fig. 9     in einem Diagramm den Verlauf der Dreiecksspannung, der Ausgangsspannung des Differentialverstärkers und der Ausgangsspannung des Spitzenwertdetektors.

In der nachfolgenden Beschreibung werden in den Figuren gleiche oder gleichwirkende Elemente mit den gleichen Bezugszeichen versehen, so dass deren Beschreibung in den unterschiedlichen Ausführungsbeispielen untereinander austauschbar ist.

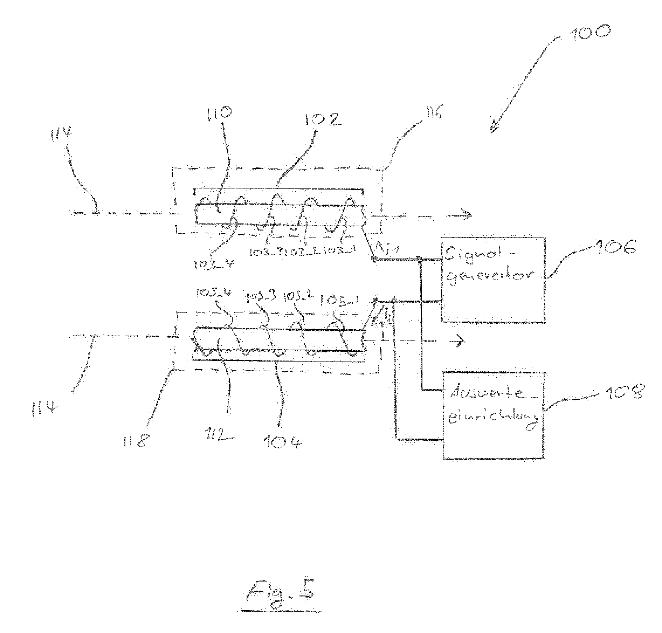

Fig. 5 zeigt ein Blockschaltbild eines Magnetfeldsensors 100 gemäß einem Ausführungsbeispiel der vorliegenden Erfindung. Der Magnetfeldsensor 100 weist einem ersten Strompfad 116, einen zweiten Strompfad 118, einen Signalgenerator 106 und eine Auswerteeinrichtung 108 auf. Der erste Strompfad 116 weist einen ersten Spulenbereich 102 und der zweite Strompfad 118 einen zweiten Spulenbereich 104 auf, wobei der erste Spulenbereich 102 Wicklungen in einer ersten Wickelrichtung um einen ersten magnetischen Kernbereich 110 aufweist, und wobei der zweite Spulenbereich 104 Wicklungen in einer zweiten Wickelrichtung um einen zweiten magnetischen Kernbereich 110 aufweist. Der Signalgenerator 106 ist ausgebildet, um einen Anregungsstrom i bereitzustellen, der sich auf den ersten und zweiten Strompfad 116 und 118 aufteilt. Die Auswerteeinrichtung 108 ist ausgebildet, um eine Spannung zwischen dem ersten und zweiten Spulenbereich 102 und 104 abzugreifen, und um basierend auf der Spannung ein externes Magnetfeld 114 zu detektieren.

Mit anderen Worten, bei Ausführungsbeispielen weist der Magnetfeldsensor 100 einen ersten und zweiten Spulenbereich 102 und 104, einen Signalgenerator 106 und eine Auswerteeinrichtung 108 auf. Der erste Spulenbereich 102 weist Wicklungen $103\_1$ bis $103\_n$ in einer ersten Winkelrichtung um einen ersten magnetischen Kernbereich 110 auf, wobei der zweite Spulenbereich 104 Wicklungen $105\_1$ bis $105\_m$ in einer zweiten Wickelrichtung um einen zweiten magnetischen Kernbereich 112 aufweist. Der Signalgenerator 106 ist ausgebildet, um einen ersten Strom $i_1$ in den ersten Spulenbereich 102 und einem zweiten Strom $i_2$ in den zweiten Spulenbereich 104 einzuprägen. Die Auswärtseinrichtung 108 ist ausgebildet, um eine Spannung zwischen dem ersten und zweiten Spulenbereich 102 und 104 abzugreifen, und um basierend auf der Spannung ein externes Magnetfeld 114 zu detektieren.

Bei Ausführungsbeispielen weist der erste Spulenbereich 102 Wicklungen $103\_1$ bis $103\_n$ in einer ersten Wickelrichtung um einen ersten magnetischen Kernbereich 110 auf, wobei der zweite Spulenbereich 104 Wicklungen $105\_1$ bis $105\_m$ in einer zweiten Wickelrichtung um einen zweiten magnetischen Kernbereich 112 aufweist. Durch Bereitstellen eines Anregungsstroms, der sich auf den ersten Strompfad und den zweiten Strompfad aufteilt, wird in dem ersten Spulenbereich 102 ein erstes magnetisches Feld mit einer ersten magnetischen Feldstärke $H_1$ (im Inneren des ersten Spulenbereichs 102) erzeugt, wodurch der erste magnetische Kernbereich 110 magnetisiert wird und sich eine erste magnetische Flussdichte B' im ersten magnetischen Kernbereich 110 betragsmäßig erhöht, während in dem zweiten Spulenbereich 102 ein zweites magnetisches Feld mit einer zweiten magnetischen Feldstärke $H_2$ (im Inneren des zweiten Spulenbereichs 102) erzeugt wird, wodurch auch der zweite magnetische Kernbereich 112 magnetisiert wird und sich eine zweite magnetische Flussdichte B" im zweiten magnetischen Kernbereich 110 betragsmäßig erhöht. Dadurch, dass der erste Spulenbereich 102 Wicklungen in einer ersten Wickelrichtung aufweist, während der zweite Spulenbereich 104 Wicklungen in einer zweiten Wickelrichtung aufweist, ist die erste magnetische Feldstärke $H_1$ in eine erste Richtung gerichtet, während die zweite magnetische Feldstärke $H_2$ in eine zweite Richtung gerichtet ist. In Anwesenheit eines externen Magnetfelds mit einer externen

magnetischen Feldstärke $H_{ext}$ überlagern sich die erste magnetische Feldstärke $H_1$ und die externe magnetische Feldstärke $H_{ext}$ in Abhängigkeit der Richtung der externen magnetischen Feldstärke $H_{ext}$ und des ersten Stroms $i_1$ z.B. konstruktiv (oder destruktiv), womit die erste magnetische Flussdichte B' erhöht (oder reduziert) wird, während sich die zweite magnetische Flussdichte und die magnetische Flussdichte des externen Magnetfelds in Abhängigkeit der Richtung der externen magnetischen Feldstärke $H_{ext}$ und des zweiten Stroms $i_2$ destruktiv (oder konstruktiv) überlagern, wodurch die zweite magnetische Flussdichte B'' reduziert (oder erhöht) wird. Dies führt dazu, dass, bei entsprechendem Anregungsstrom, der sich auf den ersten Strompfad und den zweiten Strompfad aufteilt, der erste magnetische Kernbereich zu einem ersten Zeitpunkt in Sättigung gelangt, während der zweite magnetische Kernbereich 112 zu einem zweiten Zeitpunkt in Sättigung gelangt. Zwischen dem ersten Zeitpunkt, zudem der erste magnetischen Kernbereich 110 in Sättigung gelangt und dem zweiten Zeitpunkt, zu dem der zweite magnetische Kernbereich 112 in Sättigung gelangt, weisen der erste Spulenbereich 102 und der zweite Spulenbereich 104 unterschiedliche elektrische Eigenschaften auf, so dass die Auswerteeinrichtung 108 basierend auf der Spannungsdifferenz zwischen dem ersten Spulenbereich 102 und dem zweiten Spulenbereich 104 das externe Magnetfeld des detektieren kann.

Bei Ausführungsbeispielen kann der Signalgenerator 106 ausgebildet sein, um einen Anregungsstrom i bereitzustellen, der sich auf den ersten Strompfad 116 und den zweiten Strompfad 118 aufteilt. Somit fließt in dem ersten Strompfad 116 ein erster Strom $i_1$ und in dem zweiten Strompfad $i_2$ ein zweiter Strom. Die Summe des ersten Stroms $i_1$ und des zweiten Stroms $i_2$ kann dabei gleich des Anregungsstroms i sein ($i = i_1 + i_2$). Bei Ausführungsbeispielen können der erste Strompfad 116 und der zweite Strompfad 118 symmetrisch sein, so dass sich der Anregungsstrom i gleichmäßig auf den ersten Strompfad 116 und den zweiten Strompfad 118 aufteilt ($i_1 = i_2$).

Bei Ausführungsbeispielen können die erste Wickelrichtung und die zweite Wickelrichtung unterschiedlich sein, z.B. gegenläufig. Beispielsweise können die Wicklungen 103_1 bis 103_n des ersten Spulenbereichs 102 Helixförmig (oder Schraubenförmig) im Uhrzeigersinn um den ersten Kernbereich 110 angeordnet sein, während die Wicklungen 105_1 bis 105_m des zweiten Spulenbereichs 10 Helixförmig (oder Schraubenförmig) gegen den Uhrzeigersinn um den zweiten Kernbereich 112 angeordnet sein können.

Ferner können der erste Spulenbereich 102 und der zweite Spulenbereich 104 im Wesentlichen parallel zueinander verlaufen. Beispielsweise würde somit ein externes Magnetfeld 114 mit einer externen magnetischen Feldstärke $H_{ext}$, die im Wesentlichen parallel zu dem ersten und zweiten Spulenbereich 102 und 104 verläuft, z.B. zu einer konstruktiven (oder destruktive) Überlagerung der ersten magnetischen Feldstärke $H_1$ des

ersten Spulenbereichs 102 und der magnetischen Feldstärke $H_{ext}$ des externen Magnetfelds 114, und zu einer destruktiven (oder konstruktiven) Überlagerung der zweiten magnetischen Feldstärke $H_2$ des zweiten Spulenbereichs 104 und der magnetischen Feldstärke $H_{ext}$ des externen Magnetfelds 114 führen. Selbstverständlich kann der Magnetfeldsensor 100 auch genutzt werden, um ein externes Magnetfeld 114 zu detektieren, dessen magnetische Flussdichte in einem Winkel $\alpha$ zu dem ersten und/oder zweiten Spulenbereich 102 und 104 verläuft, wobei der Winkel $\alpha$ kleiner als 80°, 70°, 60°, 50°, 40°, 30°, 20°, 10°, 5°, 3°, oder 1° sein kann.

Des Weiteren können eine Anzahl n von Wicklungen (Wicklungszahl) 103_1 bis 103_n des ersten Spulenbereichs 102 gleich einer Anzahl m von Wicklungen (Wicklungszahl) 105_1 bis 105_m des zweiten Spulenbereichs 104 sein (n = m), wobei n und m natürliche Zahlen sein können. Beispielsweise können der erste und zweite Spulenbereich 102 und 104 jeweils mehr als 5, 10, 20, 30, 40, 50, 60, 70, 80, 90, 100, 150, 200, 300, 400, 500, 600, 700, 800, 900 oder 1000 Wicklungen aufweisen. Selbstverständlich können der erste und zweite Spulenbereich 102 und 104 auch unterschiedliche Wicklungszahlen aufweisen, wobei in diesem Fall die Empfindlichkeit des Magnetfeldsensors 100 reduziert wird.

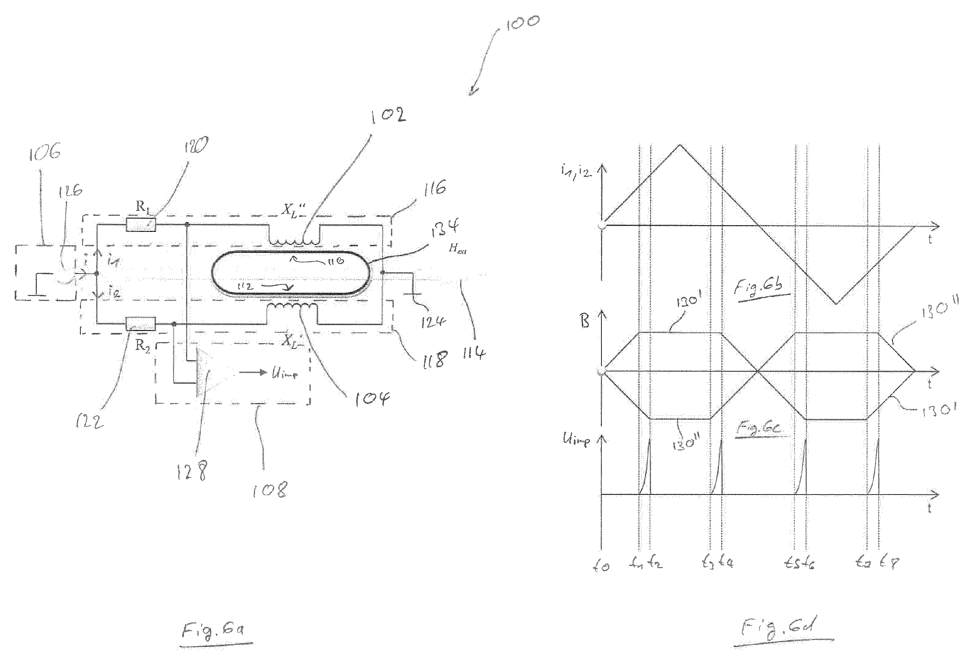

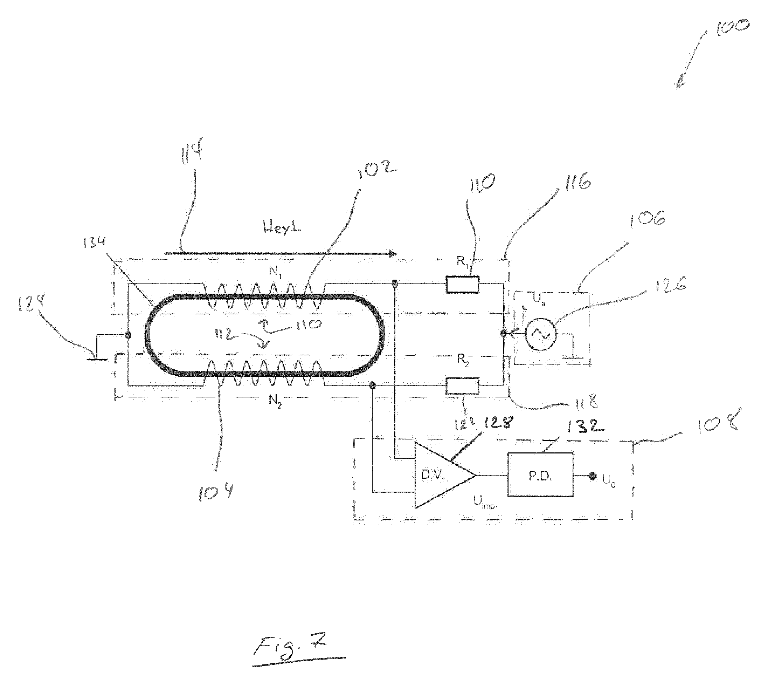

Bei Ausführungsbeispielen kann der Magnetfeldsensor 100 einen magnetischen Kern aufweisen, der den ersten und zweiten magnetischen Kernbereich 110 und 112 umfasst. Mit anderen Worten, der Magnetfeldsensor 100 kann einen magnetischen Kern 134 aufweisen (siehe z.B. Fig. 6a und 7), wobei ein erster Bereich des magnetischen Kerns den ersten magnetischen Kernbereich 110 bildet, und wobei ein zweiter Bereich des magnetischen Kerns den zweiten magnetischen Kernbereich 112 bildet. Beispielsweise kann der magnetische Kern ein ferromagnetischer oder ferrimagnetischer Ringkern sein, wobei gegenüberliegende (z.B. voneinander beabstandete) Bereiche des Ringkerns den ersten Kernbereich 110 und den zweiten Kernbereich 112 bilden können.

Bei Ausführungsbeispielen kann der magnetische Kern z.B. ein Ringkern, ein doppelter Streifenkern (engl.: double strip core), ein doppelter Stabkern (engl.: double rod core), ein rechteckiger Kern, ein quadratischer Kern, ein hexagonaler Kern oder ein oktogonaler Kern sein.

Bei Ausführungsbeispielen kann der Magnetfeldsensor 100 einen ersten und zweiten magnetischen Kern aufweisen, wobei der erste magnetische Kern den ersten Kernbereich 110 umfasst, und wobei der zweite magnetische Kern den zweiten Kernbereich umfasst. Mit anderen Worten, der Magnetfeldsensor 100 kann einen ersten und zweiten magnetischen Kern aufweisen, wobei zumindest ein Bereich des ersten magnetischen Kerns den ersten Kernbereich bildet, und wobei zumindest ein Bereich des zweiten magnetischen Kerns den zweiten Kernbereich bildet. Beispielsweise können der erste und zweite magnetische Kern ferromagnetische oder ferrimagnetische Kerne sein.

Bei Ausführungsbeispielen kann der Magnetfeldsensor 100 eine erste und zweite Spule aufweisen, wobei die erste Spule den ersten Spulenbereich 102 umfasst, und wobei die zweite Spule den zweiten Spulenbereich 104 umfasst. Mit anderen Worten, der Magnetfeldsensor 100 kann eine erste und zweite Spule aufweisen, wobei zumindest ein Bereich der ersten Spule den ersten Spulenbereich 102 bildet, und wobei zumindest ein Bereich der zweiten Spule den zweiten Spulenbereich 104 bildet. Der erste Spulenbereich 102 kann somit der Bereich der ersten Spule sein, der Wicklungen $103\_1$ bis $103\_n$ um den ersten magnetischen Kernbereich 110 aufweist, während der zweite Spulenbereich 112 der Bereich der zweiten Spule sein kann, der Wicklungen $105\_1$ bis $105\_m$ um den zweiten magnetischen Kernbereich 112 aufweist.

Fig. 6a zeigt ein Blockschaltbild eines Magnetfeldsensors 100 gemäß einem weiteren Ausführungsbeispiel der vorliegenden Erfindung. Der Magnetfeldsensor 100 weist eine erste und zweite Spule 102 und 104 auf, wobei die erste Spule 102 den ersten Spulenbereich 102 bildet, und wobei die zweite Spule 104 den zweiten Spulenbereich 104 bildet.

Ferner kann der Magnetfeldsensor 100 eine Brückenschaltung aufweisen, wobei der erste Strompfad 116 einen ersten Brückenzweig 116 der Brückenschaltung bildet und wobei der zweite Strompfad 118 einen zweiten Brückenzweig der Brückenschaltung 118 bildet. Die Auswerteeinrichtung 108 kann ausgebildet sein, um die Spannung zwischen dem ersten und zweiten Brückenzweig 116 und 118 abzugreifen. Ferner kann der Magnetfeldsensor 100 einen ersten und zweiten Widerstand 120 ($R_1$) und 122 ($R_2$) aufweisen, wobei der erste Brückenzweig 116 den ersten Widerstand 120 und der zweite Brückenzweig 118 den zweiten Widerstand 122 umfasst.

Der erste und zweite Brückenzweig 116 und 118 können jeweils in Reihe zwischen einem Referenzanschluss 124 und dem Signalgenerator 106 geschaltet sein, wobei der Referenzanschluss 124 ausgebildet sein kann, um ein Referenzpotential bereitzustellen. Beispielsweise kann der Referenzanschluss 124 ein Masseanschluss 124 sein, der ausgebildet ist, um ein Massepotential bereitzustellen. Selbstverständlich kann der Referenzanschluss 124 auch ein anderes Potential bereitstellen.

Der Signalgenerator 106 kann ausgebildet sein, um eine Dreiecksspannung zu generieren, wobei der erste und zweite Strom $i_1$ und $i_2$ auf der Dreiecksspannung basieren. Beispielsweise kann der Signalgenerator 106 eine Dreiecksspannungsquelle 126 aufweisen, die ausgebildet ist, um die Dreiecksspannung bereitzustellen. In diesem Fall können der erste und zweite Widerstand 120 und 122 genutzt werden, um den ersten und zweiten Strom $i_1$ und $i_2$ einzustellen.

Die Auswerteeinrichtung 108 kann einen Differenzverstärker 128 aufweisen, der ausgebildet ist, um die Spannungsdifferenz zwischen dem ersten und zweiten Spulenbereich 102 und 104 abzugreifen und zu verstärken, um eine Ausgangsspannung $U_{Imp}$ (Impulsspannung) zu erhalten.

Durch einprägen des ersten Stroms $i_1$ in die erste Spule 102 wird ein erstes magnetisches Feld mit einer ersten magnetischen Feldstärke $H_1$ (im Inneren des ersten Spulenbereichs 102) erzeugt, wodurch der erste magnetische Kernbereich 110 magnetisiert wird und sich die erste magnetische Flussdichte B' im ersten magnetischen Kernbereich 110 betragsmäßig erhöht. Durch einprägen des zweiten Stroms $i_2$ in die zweite Spule 102 wird ein zweites magnetisches Feld mit einer zweiten magnetischen Feldstärke $H_2$ (im Inneren des zweiten Spulenbereichs 102) erzeugt, wodurch auch der zweite magnetische Kernbereich 112 magnetisiert wird und sich die zweite magnetische Flussdichte B" im zweiten magnetischen Kernbereich 110 betragsmäßig erhöht. Die externe magnetische Feldstärke $H_{ext}$ überlagert sich mit der ersten magnetischen Feldstärke $H_1$ in Abhängigkeit von der Richtung der externen magnetischen Feldstärke $H_{ext}$ und des ersten Stroms $i_1$ z.B. konstruktiv (oder destruktiv), womit die erste magnetische Flussdichte B' erhöht (oder reduziert) wird, während sich die externe magnetische Feldstärke $H_{ext}$ mit der zweiten magnetischen Feldstärke $H_2$ in Abhängigkeit von der Richtung der externen magnetischen Feldstärke $H_{ext}$ und des zweiten Stroms $i_2$ z.B. destruktiv (oder konstruktiv) überlagert, womit die zweite magnetische Flussdichte B" reduziert (oder erhöht) wird. Dies führt dazu, dass, bei entsprechendem ersten Strom $i_1$ und zweiten Strom $i_2$, der erste magnetische Kernbereich 110 zu einem ersten Zeitpunkt $t_1$ in Sättigung gelangt, während der zweite magnetische Kernbereich 112 zu einem zweiten Zeitpunkt $t_2$ in Sättigung gelangt (siehe Fig. 6c). Zwischen dem ersten Zeitpunkt $t_1$, zudem der erste magnetischen Kernbereich 110 in Sättigung gelangt und dem zweiten Zeitpunkt $t_2$, zu dem der zweite magnetische Kernbereich 112 in Sättigung gelangt, weisen die erste Spule 102 und die zweite Spule 104 unterschiedliche elektrische Eigenschaften auf, so dass die Auswerteeinrichtung 108 basierend auf der Spannung zwischen der ersten Spule 102 und der zweiten Spule 104 das externe Magnetfeld 114 des detektieren kann.

Fig. 6b zeigt in einem Diagramm den Verlauf der Stromstärke des ersten Stroms $i_1$, der in die erste Spule 102 eingeprägt wird, und des zweiten Stroms $i_2$, der in die zweite Spule 102 eingeprägt wird. Dabei beschreibt die Ordinate die Stromstärke, während die Abszisse die Zeit beschreibt.

Fig. 6c zeigt in einem Diagramm den Verlauf 130' der ersten magnetischen Flussdichte B' im ersten magnetischen Kernbereich 110 und den Verlauf 130" der zweiten magnetischen Flussdichte B" im zweiten magnetischen Kernbereich 112. Dabei beschreibt die Ordinate die magnetische Flussdichte, während die Abszisse die Zeit beschreibt.

In Fig. 6c ist zu erkennen, dass bei einem positiven ersten und zweiten Strom $i_1$ und $i_2$ der erste magnetische Kernbereich 110 durch die konstruktive Überlagerung der externen magnetischen Feldstärke $H_{ext}$ und der ersten magnetischen Feldstärke $H_1$ bereits zum Zeitpunkt $t_1$ in Sättigung gelangt, während der zweite magnetische Kernbereich 112 durch die destruktiven Überlagerung der externen magnetischen Feldstärke $H_{ext}$ und der zweiten magnetischen Feldstärke $H_2$ erst zum Zeitpunkt $t_2$ in Sättigung gelangt. Dementsprechend gelangt der zweite magnetische Kernbereich 112 bereits zum Zeitpunkt $t_3$ aus der Sättigung, während der erste magnetische Kernbereich 110 erst zum Zeitpunkt $t_4$ aus der Sättigung gelangt.

Bei einem negativen ersten und zweiten Strom $i_1$ und $i_2$ gelangt der zweite magnetische Kernbereich 112 durch die konstruktive Überlagerung der externen magnetischen Feldstärke $H_{ext}$ und der zweiten magnetischen Feldstärke $H_2$ bereits zum Zeitpunkt $t_5$ in Sättigung, während der erste magnetische Kernbereich durch die destruktive Überlagerung der externen magnetischen Feldstärke $H_{ext}$ und der ersten magnetischen Feldstärke $H_1$ erst zum Zeitpunkt $t_6$ in Sättigung gelangt. Dementsprechend gelangt der erste magnetische Kernbereich 110 bereits zum Zeitpunkt $t_7$ aus der Sättigung, während der zweite magnetische Kernbereich 112 erst zum Zeitpunkt $t_8$ aus der Sättigung gelangt.

Fig. 6d zeigt in einem Diagramm den Verlauf der Ausgangsspannung $U_{imp}$ des Differenzverstärkers 128. Dabei beschreibt die Ordinate die Spannung, während die Abszisse die Zeit beschreibt. Wie in Fig. 6d zu erkennen ist, weist die Ausgangsspannung $U_{imp}$ des Differenzverstärkers 128 zwischen den Zeitpunkten $t_1$ und $t_2$, $t_3$ und $t_4$, $t_5$ und $t_6$, und $t_7$ und $t_8$ Spannungsimpulse auf. Die Spannungsimpulse steigen dabei an, wenn ein erster Bereich der zwei Kernbereiche 110 und 112 in Sättigung gelangt, und erreichen ihr Maximum kurz bevor ein zweiter Bereich der zwei Kernbereiche 110 und 112 in Sättigung gelangt. Anschließend fallen die Spannungsimpulse rapide ab.

Mit anderen Worten, Ausführungsbeispiele der vorliegenden Erfindung beschreiben ein neues Verfahren, um die Messung von magnetischen Feldstärken 114 einfach und präzise (mit hoher zeitlicher Auflösung und somit eines hohen Frequenzmessbereichs) durchzuführen.

Das entwickelte Sensorkonzept eliminiert die Sekundärspule aus der Schaltungstopologie und befreit damit das Gesamtsystem von den bisher bestehenden Abhängigkeiten hinsichtlich Abstimmung des Schwingkreises, feste Betriebsfrequenz bzw. Limitierung der messbaren Frequenzen und Möglichkeiten hinsichtlich Miniaturisierung gerade bei hochempfindlichen Sensoren.

Eine wesentliche Besonderheit der vorliegenden Erfindung ist, dass über das klassische Messwertspektrum bestehender Fluxgate-Sensoren hinaus Feldstärken von sehr schwachen Magnetfeldern präzise gemessen werden können. Darüber hinaus können Wechselfelder mit sehr hohen Frequenzen registriert werden.

Im Folgenden werden wesentliche Verbesserungen von Ausführungsbeispielen der vorliegenden Erfindung gegenüber bestehenden Technologien aufgeführt. Erstens, Ausführungsbeispiele ennöglichen eine Realisierung des Fluxgate-Sensors 100 mit nur einer Spulenwicklung (geteilte Primärspule). Zweitens, Ausführungsbeispiele ermöglichen es, die Frequenz für den Anregungsstrom in der Primärspule (Magnetisierung) frei zu wählen. Drittens, bei Ausführungsbeispielen ist keine Schwingkreisabstimmung erforderlich (da Sekundärspule entfällt). Viertens, Ausführungsbeispiele ermöglichen eine Erweiterung des messbaren Frequenzspektrums (von einem niederfrequenten Bereich bis in einen hochfrequenten Bereich, z.B. von DC bis 1 MHz, oder sogar bis ins Unendliche, statt bisher einige 10 kHz). Die Erweiterung der Messung externer Magnetwechselfelder kann somit vom bisherigen Limit einiger 10 kHz (klassische Technologie) theoretisch ohne Einschränkung erfolgen (aufgrund des Sensorprinzips). Einzige Einschränkungen sind der Signalgenerator und die Auswerteeinheit. Fünftens, Ausführungsbeispiele weisen eine verbesserte Empfindlichkeit ohne höhere Wicklungszahl auf. Sechstens, Ausführungsbeispiele erweisen kleinere Abmessungen bei hoher Empfindlichkeit auf. Siebtens, bei Ausführungsbeispielen ist aufgrund des Sensorkonzepts eine weitere Miniaturisierung gut möglich. Achtens, Ausführungsbeispiele schaffen mehr Flexibilität hinsichtlich der geometrischen Auslegung des Fluxgate-Sensors 100. Neuntens, Ausführungsbeispiele weisen ein verbessertes zeitliches Auflösungsvermögen auf. Zehntens, Ausführungsbeispiele ermöglichen eine präzise Messung auch von sehr schwachen Magnetfeldern.

Im Gegensatz zu bekannten Fluxgate-Sensoren, weist der erfindungsgemäße Magnetsensor keine kapazitive Kopplung in den Strompfaden auf. Darüber hinaus wird im Gegensatz zu bekannten Fluxgate-Sensoren die Spannungsdifferenz nur über die Spulen 102 und 104 gemessen. Des Weiteren werden im Gegensatz zu bekannten Fluxgate-Sensoren die Strompfade 102 und 104 parallel angeregt.

Der wesentliche Lösungsansatz der vorgestellten Erfindung besteht darin, die Messung von Magnetfeldern 114 über eine Stromstärkeänderung in einer geteilten (Primär)Spule 102 und 104 zu erfassen, die auf einen Ringkern 134 aufgewickelt ist. Die Messung erfolgt also nicht wie bisher bei klassischen Fluxgate-Sensoren über die Erfassung einer induzierten Spannung in einer Sekundärspule. Die Stromstärkeänderung kommt aufgrund der Überlagerung von externen Magnetfeldern 114 und einer induzierten Magnetisierung im Ringkern 134 zustande.

Fluxgate-Sensoren, die aus einem Ringkern aus weichmagnetischen Werkstoffen bestehen, sind in der Magnetforschung schon lange bekannt [P. Ripka. Magnetic Sensors and Magnetometers. Artech House Publishers, 81-83, 2001.] Dieser Typ des Fluxgate-Sensors ist bereits sehr empfindlich. In der experimentellen Forschung können mit dieser Art des Fluxgate-Sensors Messungen mit geringem magnetischen Rauschen durchgeführt werden. Diese Eigenschaft wird auch in der vorliegenden Erfindung aufgegriffen und umgesetzt.

Der Ringkern 134 wurde in einer ovalen Form gefertigt und besteht aus einigen Windungen eines dünnen, weichmagnetischen Bandes mit sehr hoher magnetischer Permeabilität. Das Band ist aus einer Kobalt-Eisenlegierung hergestellt, die mit einer hohen magnetischen Permeabilität $\mu$ und mit einer kleinen Koerzitivfeldstärke charakterisiert ist. Solche Legierungen verfügen über ein niedriges magnetisches Rauschniveau und weisen nur ein geringes Maß an Anisotropie auf. Außerdem verfügen diese Legierungen über die gute Temperaturstabilität und einen hohen spezifischen Widerstand. Dieser macht den Kern 134 besonders geeignet für den Einsatz bei hohen Frequenzen.

Für die Erfassung und Messung von induzierten Spannungen, die aufgrund von Magnetfeldüberlagerung im Inneren des Ringkerns 134 eines Fluxgate-Sensors entstehen, wird in klassischer Bauweise als wesentliches Element eine Sekundärspule verwendet. Dieses Konzept stellt jedoch eine komplizierte Realisierung von Fluxgate-Sensoren dar. Die vorliegenden Erfindung beschreibt eine neue Methode, bei der auf den Einsatz einer Sekundärspule verzichtet werden kann und lediglich eine geteilte Primärspule 102 und 104 zum Einsatz kommt, die auf einen Ringkern 134 aufgebracht ist. Die Messung der Magnetfeldüberlagerung im Inneren des Ringkerns 134 wird dabei dann über Stromstärkeänderung in der geteilten Primärspule 102 und 104 gemessen.

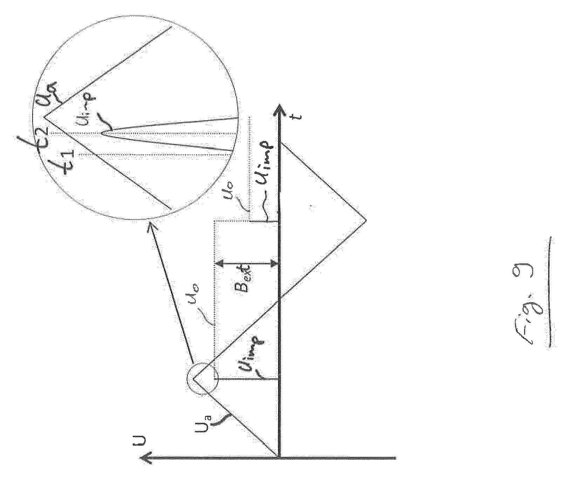

Fig. 7 zeigt ein Blockschaltbild eines Magnetfeldsensors 100 gemäß einem Ausführungsbeispiel der vorliegenden Erfindung. Der Magnetfeldsensor 100 weist eine erste Spule 102 mit Wicklungen in einer ersten Wickelrichtung um einen ersten magnetischen Kernbereich 110 eines magnetischen Ringkerns 134, eine zweite Spule 104 mit Wicklungen in einer zweiten Wickelrichtung um einen zweiten magnetischen Kernbereich 112 des magnetischen Ringkerns 134, einen ersten Widerstand 120, einen zweiten Widerstand 122, einen Signalgenerator 106 und eine Auswerteeinrichtung 108 auf. Die erste Spule 102 und der erste Widerstand 120 sind in Reihe geschaltet und bilden einen ersten Brückenzweig 116 einer Brückenschaltung. Die zweite Spule 104 und der zweite Widerstand 122 sind in Reihe geschaltet und bilden einen zweiten Brückenzweig 118 der Brückenschaltung. Der erste und zweite Brückenzweig 116 und 118 sind dabei jeweils in Reihe zwischen einem Referenzanschluss 124 und dem Signalgenerator 126 geschaltet. Der Signalgenerator 106 weist eine Dreiecksspannungsquelle 126 auf, die ausgebildet ist, um eine Dreiecksspannung $U_a$ an den ersten und zweiten Brückenzweig 116 und 118 anzulegen. Die Auswerteeinrichtung 108 weist einen Differenzverstärker 128 auf, der ausgebildet ist, um eine Spannung zwischen dem ersten und zweiten Brückenzweig 116 und 118 abzugreifen und zu verstärken, um eine Ausgangsspannung $U_{imp}$ zu erhalten. Ferner weist die Auswerteeinrichtung 108 einen Spitzenwertdetektor 132 auf, der ausgebildet ist, um einen Spitzenwert der Ausgangsspannung $U_{imp}$ des Differenzverstärkers 128 zu detektieren und um den detektierten Spitzenwert als Ausgangsspannung $U_0$ der Auswerteeinrichtung 108 auszugeben. Mit anderen Worten, die Auswerteeinrichtung 108 weist einen Spitzenwertdetektor 132 auf, der ausgebildet ist, um einen Spitzenwert der Ausgangsspannung $U_{imp}$ des Differenzverstärkers 128 zu detektieren und (z.B. für einen vorgegebenen Zeitraum oder bis zur Detektion eines auf den Spitzenwert zeitlich nachfolgenden Spitzenwerts) zu halten (gestrichelte Linie 150 in Fig. 9). Der Spitzenwert der Ausgangsspannung $U_{imp}$ ist dabei ein Maß für das externe Magnetfeld 114 bzw. die externe magnetische Flussdichte $B_{ext}$ (siehe Fig. 9).

Mit anderen Worten, der Sensor 100 umfasst einen amorphen bzw. ferromagnetischen Ringkern 134 und eine geteilte Primärspule (Anregungsspulen $N_1$ (102) und $N_2$ (104)). Die Spulen 102 und 104 befinden sich auf zwei Seiten des Ringkerns 134. An die Spulen $N_1$ und $N_2$ ist über die Widerstände 120 und 122 der Generator 106 eines Dreiecksignals angeschlossen, der die Wechselspannung $U_a$ für das anregende magnetische Hilfsfeld erzeugt und damit den Magnetisierungsstrom $I_a$ ($i_1$) und $i_2$) in die Primärspule einprägt.

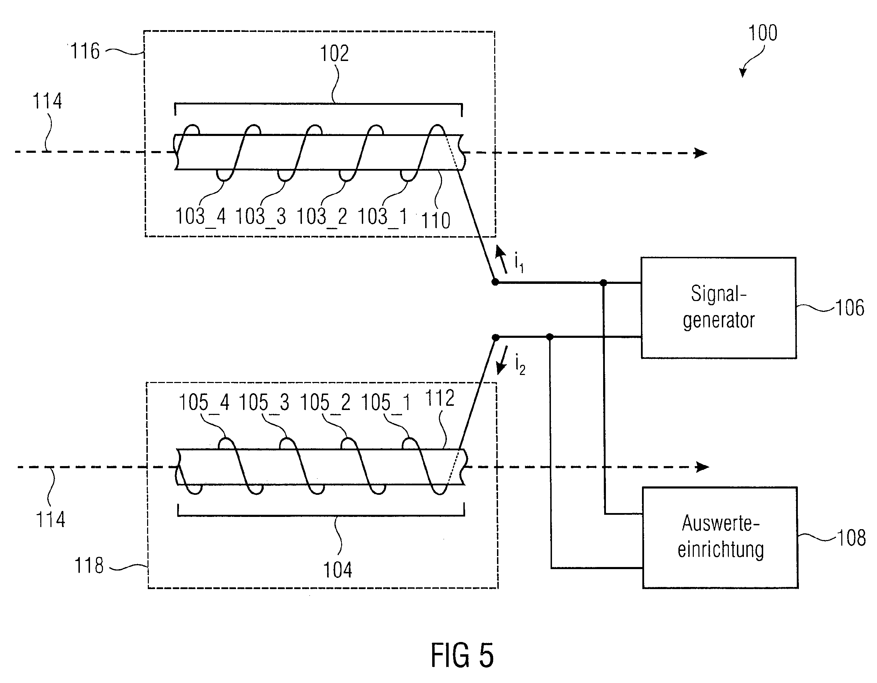

Die Widerstände $R_1$ und $R_2$ dienen als Stromteiler und für die Begrenzung des Spulenstroms. In den beiden Strompfaden über R1 und N1 sowie über R2 und N2 ergibt sich jeweils ein Spannungsteiler für $U_a$. Dieser Spannungsteiler ist gleich, wenn kein externes Magnetfeld 114 vorherrscht. Ist ein externes Magnetfeld wirksam, entsteht in den Spulenwicklungen der geteilten Primärspule 102 und 104 eine induzierte Spannung. Aufgrund der geometrischen, gegenläufigen Anordnungen N1 und N2 kommt es in den beiden Spulen 102 und 104 zu einer konstruktiven bzw. destruktiven Überlagerung mit dem externen Magnetfeld 114. Dies führt dazu, dass die Magnetisierung des Ringkerns 134 bei N1 und N2 unterschiedliche Intensitäten auf der Hystereseschleife (siehe Fig. 8a bis 8c) einnehmen und damit unterschiedliche Reserve zur magnetischen Sättigung aufweisen.

$$B' = B_{ext} + B_{in}$$

$$B'' = B_{ext} - B_{in}$$

Fig. 8a zeigt in einem Diagramm die Hysteresekurve 140 des in Fig. 7 gezeigten ferromagnetischen Ringkerns 134, wobei ein erster Punkt 130' die erste magnetische Flussdichte B' und ein zweiter Punkt 130" die zweite magnetische Flussdichte B" kennzeichnet. Dabei beschreibt die Ordinate die magnetische Flussdichte, während die Abszisse die magnetische Feldstärke beschreibt. In dem in Fig. 8a gezeigtem Beispiel ist zu erkennen, dass die erste magnetische Flussdichte B' in dem ersten magnetischen Kernbereich 110 größer ist als die zweite magnetische Flussdichte B" in dem zweiten magnetischen Kernbereich 112. Eine konstruktive Überlagerung des externen Magnetfelds $H_{ext}$ und des ersten Magnetfelds $H_1$ der ersten Spule 102 führt somit zu einer Erhöhung der ersten magnetischen Flussdichte B', während eine destruktive Überlagerung des externen Magnetfelds $H_{ext}$ und des zweiten Magnetfelds $H_2$ der zweiten Spule 104 zu einer Reduzierung der zweiten magnetischen Flussdichte B" führt.

Fig. 8b zeigt in einem Diagramm die Hysteresekurve 140 des in Fig. 7 gezeigten ferromagnetischen Ringkerns 134, wobei ein erster Punkt 130' die erste magnetische Flussdichte B' und ein zweiter Punkt 130" die zweite magnetische Flussdichte B" kennzeichnet. Dabei beschreibt die Ordinate die magnetische Flussdichte, während die Abszisse die magnetische Feldstärke beschreibt. In dem in Fig. 8b gezeigte Beispiel ist zu erkennen, dass eine Erhöhung des ersten und zweiten Stroms $i_1$ und $i_2$ zu einer Erhöhung der ersten magnetischen Flussdichte B' und der zweiten magnetischen Flussdichte B" führt, wobei der erste magnetische Kernbereich 110 bereits in Sättigung ist.

Fig. 8c zeigt in einem Diagramm die Hysteresekurve 140 des in Fig. 7 gezeigten ferromagnetischen Ringkerns 134, wobei ein erster Punkt 130' die erste magnetische Flussdichte B' und ein zweiter Punkt 130" die zweite magnetische Flussdichte B" kennzeichnet. Dabei beschreibt die Ordinate die magnetische Flussdichte, während die Abszisse die magnetische Feldstärke beschreibt. In dem in Fig. 8c gezeigte Beispiel ist zu erkennen, dass eine weitere Erhöhung des ersten und zweiten Stroms $i_1$ und $i_2$ zu einer weiteren Erhöhung der zweiten magnetischen Flussdichte B" und somit zur Sättigung des zweiten magnetischen Kernbereich 112 führt.

Die Magnetisierung des ersten und zweiten magnetischen Kernbereichs 110 und 112 in Fig. 8b entspricht dabei dem Zeitpunkt $t_1$ der Fig. 6c, während die Magnetisierung des ersten und zweiten magnetischen Kernbereichs 110 und 112 in Fig. 8c dem Zeitpunkt $t_2$ der Fig. 6c entspricht.

Mit anderen Worten, mit steigender Magnetisierung des Ringkerns 134 durch den Magnetisierungsstrom in der geteilten Primärspule 102 und 104 erreicht einer der beiden Punkte im Ringkern (im Bereich der Spule N1 oder im Bereich der Spule N2) früher den Punkt der maximalen Magnetisierung als der andere ($t_1$) (siehe Fig. 8b). In diesem Moment der maximalen Magnetisierung des Ringkerns 134 verändert die Spule ihre magnetischen Eigenschaften, so dass sich der elektrische Widerstand der Spule ebenfalls ändert und einen minimalen Wert annimmt.

Dadurch fällt auch die Spannung über der jeweiligen Spule so stark ab und verändert damit den Spannungsteiler über Spule und Widerstand im jeweiligen Strompfad (R1 + N1 bzw. R2 + N2).

Mit weiter ansteigendem Magnetisierungsstrom in der geteilten Primärspule erreicht nach kurzer Zeit auch der jeweils andere Punkt des Ringkerns die maximale Magnetisierung (Maximum der Hystereseschleife) (siehe Fig. 8c), so dass sich die elektrischen Eigenschaften der Spulen N1 und N2 ausgleichen und zu einer Kompensation der Spannungsteilerunterschiede in den beiden Strompfaden führen ($t_2$).

Der Differentialverstärker 128 greift die Spannungsunterschiede über die beiden Spulen N1 und N2 ab (siehe Fig. 9). Für den kurzen Zeitraum zwischen $t_1$ ($t_{B'max}$) und $t_2$ ($t_{B"max}$) wird aufgrund der unterschiedlichen elektrischen Eigenschaften von N1 und N2 ein Spannungsunterschied am Eingang gemessen. Der Ausgang des Differentialverstärkers 128 wird einem Peakdetektor 132 zugeführt, der eine hohe zeitliche Auflösung für die auftretenden, pulsartigen Signale ermöglicht.

Der Einsatz einer Dreiecksspannung als Anregungssignal erlaubt eine sehr gute lineare Aussteuerung für die Magnetisierung des Ringkerns.

Ausführungsbeispiele der vorliegenden Erfindung beziehen sich auf eine Vorrichtung und ein Verfahren für die Konstruktion eines Fluxgate-Sensors basierend auf einer Ringkern-Konstruktion.

Weitere Ausführungsbeispiele beziehen sich auf die Verwendung einer einfachen Spulenwicklung (bei klassischen Fluxgate-Sensoren kommt eine Primärspule um den Ringkern und eine Sekundärspule um die Primärspule herum zum Einsatz, vergleiche Fig. 1a).

Bei Ausführungsbeispielen kann die Primärspule als Anregungs- und zugleich als Detektionsspule genutzt werden (bei klassischen Fluxgate-Sensoren wird die Primärspule nur zur Anregung genutzt, die Sekundärspule nur zur Detektion der magnetisch induzierten Spule).

Weitere Ausführungsbeispiele beziehen sich auf die Messung der Magnetfeldstärke basierend auf Stromänderungen in der geteilten Primärspule als Effektüberlagerung von externem Magnetfeld und der Anregungsmagnetisierung im Ringkern (bei klassischen Fluxgate-Sensoren wird die Magnetfeldstärke als Effekt der in der Sekundärspule magnetisch induzierten Spannung gemessen).

Bei Ausführungsbeispielen ist eine flexible Frequenzwahl für den Anregungsstrom und die Messung ohne Kalibrierung möglich (klassische Fluxgate-Sensoren müssen aufgrund der Abstimmung von Primär- und Sekundärspule mit einer festen Frequenz betrieben werden).

Ausführungsbeispiele ermöglichen eine Erweiterung des Messbereichs bezüglich Frequenz des externen Magnetfeldes speziell bei empfindlichen Sensoren (klassische Fluxgate-Sensoren mit hoher Empfindlichkeit benötigen eine hohe Wicklungsanzahl für die Sekundärspule und haben dadurch eine Begrenzung hinsichtlich der maximal messbaren Frequenz bzgl. des externen Magnetfeldes).

Bei Ausführungsbeispielen weist der Fluxgate-Sensor selbst bei kleinen Abmessungen eine hohe Empfindlichkeit auf (klassische Fluxgate-Sensoren benötigen für eine hohe Empfindlichkeit eine hohe Wicklungsanzahl für die Sekundärspule und haben dadurch große Abmessungen).

Ausführungsbeispiele weisen eine hohe zeitliche Auflösung für sich ändernde externe Magnetfelder durch präzise Abtastzeitpunkte im Detektorsignal auf (klassische Fluxgate-Sensoren liefern als Ausgangssignal der Sekundärspule ein Sinussignal mit fester Frequenz, das durch das externe Magnetfeld Amplitudenmoduliert ist und nur eine bestimmte zeitliche Auflösung zulässt).

Ausführungsbeispiele der vorliegenden Erfindung schaffen ein einfaches, präzises und günstiges Verfahren zur Messung sehr schwacher Magnetfeldstärken (im Bereich von pT).

Der erfindungsgemäße Magnetfeldsensor ist besonders für die Messung biomagnetischer Signale geeignet (z.B. Magnetkardiogramm (MKG)). Ferner ermöglicht der erfindungsgemäße Magnetfeldsensor 100 deutlich einfachere Messungen von biomagnetischen Signalen im Vergleich zu klassischen Methoden, wie z.B. SQUIT.

Ausführungsbeispiele der vorliegenden Erfindung beziehen sich auf einen Sensor zur Messung von Magnetfeldern. Im Fokus des Anwendungsszenarios steht die Nutzung eines ausreichend empfindlichen Sensors für die Messung von sehr schwachen magnetischen Signalen. Für den Magnetfeldsensor sind z.B. die im Folgenden genannten Zielsetzungen für Messwerterfassung beabsichtigt. Erstens, Messung biomagnetischer Signale mit kleinsten Feldstärken, z.B. das vom Herzmuskel erzeugte magnetische Signal, das sogenannte "Magnetkardiogramm (MKG)". Zweitens, Restzeit-Messungen zum Nachweis der Abschirmungs-Wirksamkeit. Drittens, Kalibrierung von Elektromagneten in Helmholtz-Spulen zur Störfeldkompensation. Viertens, präzise Vermessung natürlicher Magnetfelder und Darstellung der Vektor-Komponenten, z.B. Erdmagnetfeld. Fünftens, Messung schwacher geomagnetischer Felder im Gestein. Sechstens industrielle Anwendung basierend auf induktiven Messverfahren bzw. Magnetfeldmessung, z.B. Prüfung von Materialdicken oder Massebestimmung.

Weitere Ausführungsbeispiele schaffen ein Verfahren zum Detektieren eines externen Magnetfelds. In einem ersten Schritt wird ein Anregungsstroms bereitgestellt, der sich auf einen ersten Strompfad mit einem ersten Spulenbereich und einen zweiten Strompfad mit einem zweiten Spulenbereich aufteilt, wobei der erste Spulenbereich Wicklungen in einer ersten Wickelrichtung um einen ersten magnetischen Kernbereich aufweist, wobei der zweite Spulenbereich Wicklungen in einer zweiten Wickelrichtung um einen zweiten magnetischen Kernbereich aufweist, und wobei der erste Spulenbereich und der zweite Spulenbereich parallel zueinander verlaufen. In einem zweiten Schritt wird eine Spannung zwischen dem ersten und zweiten Spulenbereich abgegriffen. In einem dritten Schritt wird das externe Magnetfeld basierend auf der Spannungsdifferenz zwischen dem ersten und zweiten Spulenbereich detektiert.

Weitere Ausführungsbeispiele schaffen ein Verfahren zum Detektieren eines externen Magnetfelds. In einem ersten Schritt wird ein erster Strom in einen ersten Spulenbereich und ein zweiter Strom in einen zweiten Spulenbereich eingeprägt, wobei der erste Spulenbereich Wicklungen in einer ersten Wickelrichtung um einen ersten magnetischen Kernbereich aufweist, und wobei der zweite Spulenbereich Wicklungen in einer zweiten Wickelrichtung um einen zweiten magnetischen Kernbereich aufweist. In einem zweiten Schritt wird eine Spannung zwischen dem ersten und zweiten Spulenbereich abgegriffen. In einem dritten Schritt wird das externe Magnetfeld basierend auf der Spannung zwischen dem ersten und zweiten Spulenbereich detektiert.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eine Hardware-Apparats), wie zum Beispiel einen Mikroprozessor, einen programmierbaren Computer oder eine elektronische Schaltung. Bei einigen Ausführungsbeispielen können einige oder mehrere der wichtigsten Verfahrensschritte durch einen solchen Apparat ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1. Magnetfeldsensor (100), mit folgenden Merkmalen:

   einem ersten Strompfad (116) mit einem ersten Spulenbereich (102) und einem zweiten Strompfad (118) mit einem zweiten Spulenbereich (104);

einem Signalgenerator (106), der ausgebildet ist, um einen Anregungsstrom (i) bereitzustellen, der sich auf den ersten und zweiten Strompfad aufteilt; und

einer Auswerteeinrichtung (108), die ausgebildet ist, um eine Spannung zwischen dem ersten und zweiten Spulenbereich (102; 104) abzugreifen, und um basierend auf der Spannung ein externes Magnetfeld (114) zu detektieren; wobei der erste Spulenbereich (102) Wicklungen in einer ersten Wickelrichtung um einen ersten magnetischen Kernbereich (110) aufweist, und wobei der zweite Spulenbereich (104) Wicklungen in einer zweiten Wickelrichtung um einen zweiten magnetischen Kernbereich (112) aufweist, und wobei der erste Spulenbereich (102) und der zweite Spulenbereich (104) parallel zueinander verlaufen, **dadurch gekennzeichnet dass** durch den Anregungsstrom in dem ersten Spulenbereich (102) ein erstes Magnetfeld (H1) entsteht, das den ersten magnetische Kernbereich (110) magnetisiert und eine erste magnetische Flussdichte (B') hervorruft, die in eine erste Richtung gerichtet ist, und dass in dem zweiten Spulenbereich (104) ein zweites Magnetfeld (H2) entsteht, das den zweiten magnetischen Kernbereich (112) magnetisiert und eine zweite magnetische Flussdichte (B") hervorruft, die in eine zweite Richtung gerichtet ist, so dass durch ein in die erste Richtung gerichtetes externes Magnetfeld die erste magnetische Flussdichte (B') in dem ersten Kernbereich (110) erhöht wird während die zweite magnetische Flussdichte (B") in dem zweiten Kernbereich (112) reduziert wird, wodurch bei gleichzeitiger Erhöhung des Anregungsstroms der erste magnetische Kernbereich (110) zu einem ersten Zeitpunkt in Sättigung gelangt, während der zweite magnetische Kernbereich (112) zu einem zweiten Zeitpunkt in Sättigung gelangt.

2. Magnetfeldsensor (100) nach Anspruch 1, wobei die erste Wickelrichtung und die zweite Wickelrichtung unterschiedlich sind.

3. Magnetfeldsensor (100) nach Anspruch 1 oder 2, wobei eine Anzahl von Wicklungen des ersten Spulenbereichs (102) gleich einer Anzahl von Wicklungen des zweiten Spulenbereichs (104) ist.

4. Magnetfeldsensor (100) nach einem der Ansprüche 1 bis 3, wobei der Magnetfeldsensor (100) einen magnetischen Kern (134) aufweist, der den ersten und zweiten Kernbereich (110; 112) umfasst.

5. Magnetfeldsensor (100) nach einem der Ansprüche 1 bis 3, wobei der Magnetfeldsensor (100) einen ersten und zweiten magnetischen Kern aufweist, wobei der erste magnetische Kern den ersten Kernbereich (110) umfasst, und wobei der zweite magnetische Kern (112) den zweiten Kernbereich umfasst.

6. Magnetfeldsensor (100) nach einem der Ansprüche 1 bis 5, wobei der Magnetfeldsensor (100) eine erste und zweite Spule (102;104) aufweist, wobei die erste Spule (102) den ersten Spulenbereich (102) umfasst, und wobei die zweite Spule (104) den zweiten Spulenbereich (104) umfasst.

7. Magnetfeldsensor (100) nach einem der Ansprüche 1 bis 6, wobei der Magnetfeldsensor (100) eine Brückenschaltung aufweist, wobei der erste Strompfad (116) einen ersten Brückenzweig (116) der Brückenschaltung bildet und wobei der zweite Strompfad (118) einen zweiten Brückenzweig der Brückenschaltung (118) bildet, und wobei die Auswerteeinrichtung (108) ausgebildet ist, um die Spannung zwischen dem ersten und zweiten Brückenzweig (116;118) abzugreifen.

8. Magnetfeldsensor (100) nach Anspruch 7, wobei der Magnetfeldsensor (100) einen ersten und zweiten Widerstand (120;122) aufweist, wobei der erste Brückenzweig (116) den ersten Widerstand (120) und der zweite Brückenzweig (118) den zweiten Widerstand (122) umfasst.

9. Magnetfeldsensor (100) nach einem der Ansprüche 1 bis 8, wobei der erste und zweite Brückenzweig (116;118) jeweils in Reihe zwischen einem Referenzanschluss (124) und dem Signalgenerator (106) geschaltet sind, wobei der Referenzanschluss (124) ausgebildet ist, um ein Referenzpotential bereitzustellen.

10. Magnetfeldsensor (100) nach einem der Ansprüche 1 bis 9, wobei der Signalgenerator (106) ausgebildet ist, um eine Dreiecksspannung, Reckteckspannung oder Sinusspannung zu generieren, wobei der Anregungsstrom (i) von der Spannung abhängig ist.

11. Magnetfeldsensor (100) nach einem der Ansprüche 1 bis 10, wobei die Auswerteeinrichtung (108) einen Differenzverstärker (128) aufweist, der ausgebildet ist, um die Spannung zwischen dem ersten und zweiten Spulenbereich (102;104) abzugreifen und zu verstärken, um eine Ausgangsspannung ($U_{imp}$) zu erhalten.

12. Magnetfeldsensor (100) nach Anspruch 11, wobei die Auswerteeinrichtung 108 einen Spitzenwertdetektor 132 oder einen Tiefpassfilter aufweist, der ausgebildet ist, um einen Spitzenwert der Ausgangsspannung ($U_{imp}$) zu detektieren, um das externe Magnetfeld zu detektieren.

**13.** Verfahren zum Detektieren eines externen Magnetfelds, mit folgenden Schritten:

Bereitstellen eines Anregungsstroms (i), der sich auf einen ersten Strompfad mit einem ersten Spulenbereich und einen zweiten Strompfad mit einem zweiten Spulenbereich aufteilt, wobei der erste Spulenbereich Wicklungen in einer ersten Wickelrichtung um einen ersten magnetischen Kernbereich aufweist, wobei der zweite Spulenbereich Wicklungen in einer zweiten Wickelrichtung um einen zweiten magnetischen Kernbereich aufweist, und wobei der erste Spulenbereich und der zweite Spulenbereich parallel zueinander verlaufen, so dass durch den Anregungsstrom in dem ersten Spulenbereich (102) ein erstes Magnetfeld (H1) entsteht, das den ersten magnetische Kernbereich (110) magnetisiert und eine erste magnetische Flussdichte (B') hervorruft, die in eine erste Richtung gerichtet ist, und dass in dem zweiten Spulenbereich (104) ein zweites Magnetfeld (H2) entsteht, das den zweiten magnetischen Kernbereich (112) magnetisiert und eine zweite magnetische Flussdichte (B") hervorruft, die in eine zweite Richtung gerichtet ist, so dass durch ein in die erste Richtung gerichtetes externes Magnetfeld die erste magnetische Flussdichte (B') in dem ersten Kernbereich (110) erhöht wird während die zweite magnetische Flussdichte (B") in dem zweiten Kernbereich (112) reduziert wird, wodurch bei gleichzeitiger Erhöhung des Anregungsstroms der erste magnetische Kernbereich (110) zu einem ersten Zeitpunkt in Sättigung gelangt, während der zweite magnetische Kernbereich (112) zu einem zweiten Zeitpunkt in Sättigung gelangt;

Abgreifen einer Spannung zwischen dem ersten und zweiten Spulenbereich, und Detektieren des externen Magnetfelds basierend auf der Spannung zwischen dem ersten und zweiten Spulenbereich.

**14.** Computerprogramm zur Durchführung eines Verfahrens gemäß Anspruch 13 wenn das Computerprogramm auf einem Computer oder Mikroprozessor abläuft.

**Claims**

**1.** Magnetic field sensor (100), comprising:

a first current path (116) comprising a first coil area (102) and a second current path (118) comprising a second coil area (104); a signal generator (106) which is implemented to provide an excitation current (i) which divides into the first and second current paths; and an evaluation means (108) which is implemented to tap a voltage between the first and second coil areas (102; 104) to detect an external magnetic field (114) based on the voltage; wherein the first coil area (102) comprises windings in a first winding direction around a first magnetic core area (110), and wherein the second coil area (104) comprises windings in a second winding direction around a second magnetic core area (112), and wherein the first coil area (102) and the second coil area (104) pass in parallel to each other, **characterized in that** due to the excitation current, in the first coil area (102) a first magnetic field (H1) results which magnetizes the first magnetic core area (110) and causes a first magnetic flow density (B') directed into a first direction, and that in the second coil area (104) a second magnetic field (H2) results which magnetizes the second magnetic core area (112) and causes a second magnetic flow density (B") directed into a second direction, so that by an external magnetic field directed into the first direction, the first magnetic flow density (B') in the first core area (110) is increased, while the second magnetic flow density (B") in the second core area (112) is reduced, as a result of which, when the excitation current is simultaneously increased, the first magnetic core area (110) reaches saturation at a first time, while the second magnetic core area (112) reaches saturation at a second time.

**2.** Magnetic field sensor (100) according to claim 1, wherein the first winding direction and the second winding direction are different.

**3.** Magnetic field sensor (100) according to claim 1 or 2, wherein a number of windings of the first coil area (102) is equal to a number of windings of the second coil area (104).

**4.** Magnetic field sensor (100) according to any of claims 1 to 3, wherein the magnetic field sensor (100) comprises a magnetic core (134) which comprises the first and second core areas (110; 112).

**5.** Magnetic field sensor (100) according to any of claims 1 to 3, wherein the magnetic field sensor (100) comprises a first and second magnetic core, wherein the first magnetic core comprises the first core area (110), and wherein the second magnetic core (112) comprises the second core area.

**6.** Magnetic field sensor (100) according to any of claims 1 to 5, wherein the magnetic field sensor (100) comprises a first and second coil (102;104), wherein the first coil (102) comprises the first coil area (102), and wherein the second coil (104) comprises the second coil area (104).

7. Magnetic field sensor (100) according to any of claims 1 to 6, wherein the magnetic field sensor (100) comprises a bridge circuit, wherein the first current path (116) forms a first bridge branch (116) of the bridge circuit, and wherein the second current path (118) forms a second bridge branch of the bridge circuit (118), and wherein the evaluation means (108) is implemented to tap the voltage between the first and second bridge branches (116;118).

8. Magnetic field sensor (100) according to claim 7, wherein the magnetic field sensor (100) comprises a first and a second resistor (120;122), wherein the first bridge branch (116) comprises the first resistor (120) and the second bridge branch (118) comprises the second resistor (122).

9. Magnetic field sensor (100) according to any of claims 1 to 8, wherein the first and second bridge branches (116;118) are each connected in series between a reference terminal (124) and the signal generator (106), wherein the reference terminal (124) is implemented to provide a reference potential.

10. Magnetic field sensor (100) according to any of claims 1 to 9, wherein the signal generator (106) is implemented to generate a triangular voltage, a square-wave voltage or a sinusoidal voltage, wherein the excitation current (i) depends on the voltage.

11. Magnetic field sensor (100) according to any of claims 1 to 10, wherein the evaluation means (108) comprises a differential amplifier (128) which is implemented to tap and amplify the voltage between the first and second coil areas (102;104) in order to obtain an output voltage ($U_{imp}$).

12. Magnetic field sensor (100) according to claim 11, wherein the evaluation means 108 comprises a peak value detector 132 or a low-pass filter which is implemented to detect a peak value of the output voltage ($U_{imp}$) to detect the external magnetic field (114).

13. Method for detecting an external magnetic field, comprising:

providing an excitation current (i) which divides into a first current path with a first coil area and a second current path with a second coil area, wherein the first coil area comprises windings in a first winding direction around a first magnetic core area, wherein the second coil area comprises windings in a second winding direction around a second magnetic core area, and wherein the first coil area and the second coil area pass in parallel to each other, so that due to the excitation current, in the first coil area (102) a first magnetic field (H1) results which magnetizes the first magnetic core area (110) and causes a first magnetic flow density (B') directed into a first direction, and that in the second coil area (104) a second magnetic field (H2) results which magnetizes the second magnetic core area (112) and causes a second magnetic flow density (B") directed into a second direction, so that by an external magnetic field (114) directed into the first direction, the first magnetic flow density (B') in the first core area (110) is increased, while the second magnetic flow density (B") in the second core area (112) is reduced, as a result of which, when the excitation current is simultaneously increased, the first magnetic core area (110) reaches saturation at a first time, while the second magnetic core area (112) reaches saturation at a second time;

tapping a voltage between the first and second coil areas; and

detecting the external magnetic field based on the voltage between the first and second coil areas.

14. Computer program for executing a method of claim 13, when the computer program is executed on a computer or microprocessor.

**Revendications**

1. Capteur de champ magnétique (100), aux caractéristiques suivantes:

un premier trajet de courant (116) avec une première zone de bobine (102) et un deuxième trajet de courant (118) avec une deuxième zone de bobine (104);

un générateur de signal (106) qui est configuré pour mettre à disposition un courant d'excitation (i) qui est divisé sur les premier et deuxième trajets de courant; et

un moyen d'évaluation (108) qui est conçu pour prélever une tension entre la première et la deuxième zone de bobine (102; 104) et pour détecter, sur base de la tension, un champ magnétique externe (114);

dans lequel la première zone de bobine (102) présente des enroulements dans une première direction d'enroulement autour d'une première zone de noyau magnétique (110), et dans lequel la deuxième zone de bobine (104) présente des enroulements dans une deuxième direction d'enroulement autour d'une deuxième zone de noyau magnétique (112), et dans lequel la première zone de bobine (102) et la deuxième zone de bobine (104) s'étendent parallèles entre elles, **caractérisé par le fait que** par le courant d'excitation dans la première zone de bobine (102) est créé un premier champ magnétique (H1) qui aimante la première zone de noyau magnétique (110) et cause une première densité de flux magnétique (B') qui est orientée dans une première direction, et que dans la deuxième zone de bobine (104) est créé un deuxième champ magnétique (H2) qui aimante la deuxième zone de noyau magnétique (112) et cause une deuxième densité de flux magnétique (B") qui est orientée dans une deuxième direction, de sorte que par un champ magnétique externe orienté dans la première direction la première densité de flux magnétique (B') dans la première zone de noyau (110) soit augmentée, tandis que la deuxième densité de flux magnétique (B") dans la deuxième la zone de noyau (112) est réduite, d'où, à augmentation simultanée du courant d'excitation, la première zone de noyau magnétique (110) arrive à saturation à un premier moment, tandis que la deuxième zone de noyau magnétique (112) arrive à saturation à un deuxième moment.

2. Capteur de champ magnétique (100) selon la revendication 1, dans lequel la première direction d'enroulement et la deuxième direction d'enroulement sont différentes.

3. Capteur de champ magnétique (100) selon la revendication 1 ou 2, dans lequel un nombre d'enroulements de la première zone de bobine (102) est égal à un nombre d'enroulements de la deuxième zone de bobine (104).

4. Capteur de champ magnétique (100) selon l'une des revendications 1 à 3, dans lequel le capteur de champ magnétique (100) présente un noyau magnétique (134) qui comporte la première et la deuxième zone de noyau (110; 112).

5. Capteur de champ magnétique (100) selon l'une des revendications 1 à 3, dans lequel le capteur de champ magnétique (100) présente un premier et un deuxième noyau magnétique, le premier noyau magnétique comportant la première zone de noyau (110), et le deuxième noyau magnétique (112) comportant la deuxième zone de noyau.

6. Capteur de champ magnétique (100) selon l'une des revendications 1 à 5, dans lequel le capteur de champ magnétique (100) présente une première et une deuxième bobine (102; 104), la première bobine (102) comportant la première zone de bobine (102), et la deuxième bobine (104) comportant la deuxième zone de bobine (104).

7. Capteur de champ magnétique (100) selon l'une des revendications 1 à 6, dans lequel le capteur de champ magnétique (100) présente un circuit de pont, le premier trajet de courant (116) constituant une première branche (116) du circuit de pont et le deuxième trajet de courant (118) constituant une deuxième branche du circuit de pont (118), et dans lequel le moyen d'évaluation (108) est conçu pour prélever la tension entre la première et la deuxième branche de pont (116; 118).

8. Capteur de champ magnétique (100) selon la revendication 7, dans lequel le capteur de champ magnétique (100) présente une première et une deuxième résistance (120; 122), la première branche de pont (116) comportant la première résistance (120) et la deuxième branche de pont (118) comportant la deuxième résistance (122).

9. Capteur de champ magnétique (100) selon l'une des revendications 1 à 8, dans lequel la première et la deuxième branche de pont (116; 118) sont connectées, chacune, en série entre une connexion de référence (124) et le générateur de signal (106), ladite connexion de référence (124) étant conçue pour mettre à disposition un potentiel de référence.

10. Capteur de champ magnétique (100) selon l'une des revendications 1 à 9, dans lequel le générateur de signal (106) est conçu pour générer une tension triangulaire, une tension rectangulaire ou une tension sinusoïdale, le courant d'excitation (i) dépendant de la tension.

11. Capteur de champ magnétique (100) selon l'une des revendications 1 à 10, dans lequel le dispositif d'évaluation (108) présente un amplificateur différentiel (128) qui est conçu pour prélever et amplifier la tension entre la première et la deuxième zone de bobine (102; 104), pour obtenir une tension de sortie ($U_{imp}$).

12. Capteur de champ magnétique (100) selon la revendication 11, dans lequel le moyen d'évaluation 108 présente un détecteur de valeur de crête 132 ou un filtre passe-bas qui est conçu pour détecter une valeur de crête de la tension de sortie ($U_{imp}$), pour détecter le champ magnétique externe.

13. Procédé de détection d'un champ magnétique externe, comprenant les étapes suivantes consistant à:

mettre à disposition un courant d'excitation (i) qui est divisé sur un premier trajet de courant avec une première zone de bobine et un deuxième trajet de courant avec une deuxième zone de bobine, la première zone de bobine présentant des enroulements dans une première direction d'enroulement autour d'une première zone de noyau magnétique, la deuxième zone de bobine présentant des enroulements dans une deuxième direction d'enroulement autour d'une deuxième zone de noyau magnétique, et la première zone de bobine et la deuxième zone de bobine s'étendant parallèles entre elles, de sorte que par le courant d'excitation dans la première zone de bobine (102) soit créé un premier champ magnétique (H1) qui aimante la première zone de noyau magnétique (110) et cause une première densité de flux magnétique (B') qui est orientée dans une première direction, et que dans la deuxième zone de bobine (104) soit créé un deuxième champ magnétique (H2) qui aimante la deuxième zone de noyau magnétique (112) et cause une deuxième densité de flux magnétique (B") qui est orientée dans une deuxième direction, de sorte que par un champ magnétique externe orienté dans la première direction la première densité de flux magnétique (B') dans la première zone de noyau (110) soit augmentée, tandis que la deuxième densité de flux magnétique (B") dans la deuxième zone de noyau (112) est réduite, d'où, à augmentation simultanée du courant d'excitation, la première zone de noyau magnétique (110) arrive à saturation à un premier moment, tandis que la deuxième zone de noyau magnétique (112) arrive à saturation à un deuxième moment;

prélever une tension entre la première et la deuxième zone de bobine; et

détecter le champ magnétique externe sur base de la tension entre la première et la deuxième zone de bobine.

**14.** Programme d'ordinateur pour réaliser un procédé selon la revendication 13 lorsque le programme d'ordinateur est exécuté sur un ordinateur ou un microprocesseur.

$B'' = B\,(H_{ext} + H_{in})$

$B' = B\,(H_{ext} - H_{in})$

$H_{ext}$

$H_{in}$

12

14

Fig. 1a

$H_{ext}$

v

e

16

Fig. 1b

10

Fig. 2a

Fig. 2b

Fig. 3c

Fig. 3d

Fig. 1b

Fig. 3a

EP 2 700 967 B1

Fig. 5

EP 2 700 967 B1

Fig. 6a

Fig. 6b

Fig. 6c

Fig. 6d

Fig. 7

FIG 5

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010020648 A1
- US 3218547 A
- US 2007151943 A1
- EP 0360574 A1